# EUROPEAN PATENT APPLICATION

(11) **EP 4 838 511 A1**
(43) Date of publication of application: **11.11.2026**
(21) Application number: 24940396.5
(22) Date of filing: 30.08.2024
(51) Int. Cl.: G09G 3/20, G11C 19/28

(54) **SHIFT REGISTER AND DRIVING METHOD THEREFOR, AND SCAN DRIVING CIRCUIT AND DISPLAY APPARATUS**

(30) Priority: 09.05.2024 WO PCT/CN2024/091964
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: QING, Haigang, Beijing 100176 (CN); AN, Chengguo, Beijing 100176 (CN); HU, Ming, Beijing 100176 (CN); QIU, Haijun, Beijing 100176 (CN)
(74) Representative: Cohausz & Florack
(86) International application number: PCT/CN2024/115862
(87) International publication number: WO 2025/232045

(57) **Abstract**

A shift register and a method of driving the same, a scan circuit, and a display apparatus are provided. The shift register includes a first transistor (T1) coupled between an input terminal (IN) and a first node (N1), and at least four transistors coupled in series between the first node (N1) and a second node (N2). The at least four transistors include a second transistor (T2), a tenth transistor (T10), a sixth transistor (T6), and a ninth transistor (T9). A gate electrode of the tenth transistor (T10) is controlled by a signal that is at least partially in phase with an effective voltage of a signal input to the input terminal (IN). A gate electrode of the first transistor (T1) is controlled by a signal that is at least partially in phase with the effective voltage of the signal input to the input terminal (IN). A gate electrode of the ninth transistor (T9) is controlled by a signal that is out of phase with the effective voltage of the signal input to the input terminal (IN).

## Description

### TECHNICAL FIELD

The present invention relates to display technology, and more particularly, to a shift register and a method of driving the same, a scan circuit, and a display apparatus.

### BACKGROUND

Organic Light Emitting Diode (OLED) display is one of the hotspots in the field of flat panel display research today. Unlike Thin Film Transistor-Liquid Crystal Display (TFT-LCD), which uses a stable voltage to control brightness, OLED is driven by a driving current required to be kept constant to control illumination. The OLED display panel includes a plurality of pixel units configured with pixel-driving circuits arranged in multiple rows and columns. Each pixel-driving circuit includes a driving transistor having a gate terminal connected to one gate line per row and a drain terminal connected to one data line per column. When the row in which the pixel unit is gated is turned on, the switching transistor connected to the driving transistor is turned on, and the data voltage is applied from the data line to the driving transistor via the switching transistor, so that the driving transistor outputs a current corresponding to the data voltage to an OLED device. The OLED device is driven to emit light of a corresponding brightness.

### SUMMARY

In a first aspect of the present disclosure, the embodiment of the present disclosure provides a shift register, comprising: a first transistor coupled between an input terminal and a first node; and at least four transistors coupled between the first node and a second node in series, wherein the at least four transistors comprise a second transistor, a tenth transistor, a sixth transistor, and a ninth transistor; wherein a gate electrode of the tenth transistor is controlled by a signal that is at least partially in phase with respect to an effective voltage of a signal input to the input terminal; a gate electrode of the first transistor is controlled by a signal that is at least partially in phase with respect to the effective voltage of the signal input to the input terminal; and a gate electrode of the ninth transistor is controlled by a signal that is out of phase with respect to the effective voltage of the signal input to the input terminal.

In some embodiments of the present disclosure, the respective shift register further comprises a fifth transistor coupled between the first node and an output terminal; wherein the gate electrode of the ninth transistor is controlled by a same signal provided to a first electrode of the fifth transistor.

In some embodiments of the present disclosure, the respective shift register further includes a seventh transistor; wherein a gate electrode of the seventh transistor and the gate electrode of the second transistor are coupled to the first node; and first electrodes of the seventh transistor and the sixth transistor are configured to be provided with a second power supply signal.

In some embodiments of the present disclosure, the respective shift register further includes a third transistor and a third capacitor; wherein a gate electrode of the third transistor is coupled to a second electrode of the seventh transistor and a second capacitor electrode of the third capacitor; and a second electrode of the third transistor is coupled to the second node.

In some embodiments of the present disclosure, the second transistor, the tenth transistor, the sixth transistor, and the ninth transistor are sequentially coupled between the first node and a second node in series.

In some embodiments of the present disclosure, the tenth transistor, the second transistor, the sixth transistor, and the ninth transistor are sequentially coupled between the first node and a second node in series.

In some embodiments of the present disclosure, the gate electrode of the tenth transistor is controlled by a start signal; the gate electrode of the first transistor is controlled by a first clock signal; the gate electrode of the ninth transistor is controlled by a second clock signal; and the first clock signal and the second clock signal are at least partially out of phase with respect to each other.

In some embodiments of the present disclosure, gate electrodes of the tenth transistor and the first transistor are controlled by a first clock signal; the gate electrode of the ninth transistor is controlled by a second clock signal; and the first clock signal and the second clock signal are at least partially out of phase with respect to each other.

In some embodiments of the present disclosure, the gate electrode of the tenth transistor is controlled by a second clock signal; the gate electrode of the first transistor is controlled by a first clock signal; the gate electrode of the ninth transistor is controlled by a third clock signal; and the first clock signal, the second clock signal, and the third clock signal are at least partially out of phase with respect to each other.

In some embodiments of the present disclosure, a first electrode of the tenth transistor is configured to be provided with the second power supply signal; a second electrode of the tenth transistor is coupled to a first electrode of the second transistor; and a second electrode of the second transistor is coupled to the second node.

In some embodiments of the present disclosure, a first electrode of the second transistor is configured to be provided with the second power supply signal; a second electrode of the second transistor is coupled to a first electrode of the tenth transistor; and a second electrode of the tenth transistor is coupled to the second node.

In some embodiments of the present disclosure, a first electrode of the third transistor and the first capacitor electrode of the third capacitor are configured to be provided with a same signal as a signal provided to the gate electrode of the ninth transistor.

In some embodiments of the present disclosure, a first electrode of the third transistor and the first capacitor electrode of the third capacitor are configured to be provided with a same signal as a signal provided to the gate electrode of the tenth transistor.

In some embodiments of the present disclosure, the respective shift register further comprises an eighth transistor coupled between the first node and an output terminal; and a first electrode of the third transistor is configured to be provided with a same signal as a signal provided to a gate electrode of the eighth transistor.

In a second aspect of the present disclosure, the embodiment of the present disclosure provides a scan circuit including a plurality of cascaded stages of the shift register provided in the first aspect of the present disclosure.

In a third aspect of the present disclosure, the embodiment of the present disclosure provides a display apparatus, comprising the scan circuit, and a display panel connected to the scan circuit.

In a fourth aspect of the present disclosure, the embodiment of the present disclosure provides a method of driving a shift register described above; wherein the shift register comprises: a first transistor coupled between an input terminal and a first node; and at least four transistors coupled between the first node and a second node in series, wherein the at least four transistors comprise a second transistor, a tenth transistor, a sixth transistor, and a ninth transistor; wherein the method comprises: providing an effective voltage of a signal to the input terminal; providing a signal that is at least partially in phase with respect to an effective voltage of a signal input to the input terminal to control a gate electrode of the tenth transistor; providing a signal that is at least partially in phase with respect to the effective voltage of the signal input to the input terminal to control a gate electrode of the first transistor; and providing a signal that is out of phase with respect to the effective voltage of the signal input to the input terminal to control a gate electrode of the ninth transistor.

In some embodiments of the present disclosure, the respective shift register further comprises a fifth transistor coupled between the first node and the output terminal; wherein the method further comprises providing a control signal to the gate electrode of the ninth transistor, the control signal is the same as a signal provided to a first electrode of the fifth transistor.

In some embodiments of the present disclosure, the respective shift register further includes a seventh transistor; wherein the method further comprises: coupling a gate electrode of the seventh transistor and the gate electrode of the second transistor to the first node; and providing a second power supply signal to first electrodes of the seventh transistor and the sixth transistor.

In some embodiments of the present disclosure, the respective shift register further includes a third transistor and a third capacitor; wherein the method further comprises: coupling a gate electrode of the third transistor to a second electrode of the seventh transistor and a second capacitor electrode of the third capacitor; and coupling a second electrode of the third transistor to the second node.

In some embodiments of the present disclosure, the method further comprises sequentially coupling the second transistor, the tenth transistor, the sixth transistor, and the ninth transistor in series between the first node and a second node.

In some embodiments of the present disclosure, the method further comprises sequentially coupling the tenth transistor, the second transistor, the sixth transistor, and the ninth transistor in series between the first node and a second node.

In some embodiments of the present disclosure, the method further comprises providing a start signal to the gate electrode of the tenth transistor as a control signal; providing a first clock signal to the gate electrode of the first transistor as a control signal; and providing a second clock signal to the gate electrode of the ninth transistor; wherein the first clock signal and the second clock signal are at least partially out of phase with respect to each other.

In some embodiments of the present disclosure, the method further comprises providing a first clock signal to gate electrodes of the tenth transistor and the first transistor as a control signal; and providing a second clock signal to the gate electrode of the ninth transistor as a control signal; wherein the first clock signal and the second clock signal are at least partially out of phase with respect to each other.

In some embodiments of the present disclosure, the method further comprises providing a second clock signal to the gate electrode of the tenth transistor as a control signal; providing a first clock signal to the gate electrode of the first transistor as a control signal; and providing a third clock signal to the gate electrode of the ninth transistor as a control signal; wherein the first clock signal, the second clock signal, and the third clock signal are at least partially out of phase with respect to each other.

In some embodiments of the present disclosure, the method further comprises providing the second power supply signal to a first electrode of the tenth transistor; coupling a second electrode of the tenth transistor to a first electrode of the second transistor; and coupling a second electrode of the second transistor to the second node.

In some embodiments of the present disclosure, the method further comprises providing the second power supply signal to a first electrode of the second transistor; coupling a second electrode of the second transistor to a first electrode of the tenth transistor; and coupling a second electrode of the tenth transistor to the second node.

In some embodiments of the present disclosure, the method further comprises providing a same signal to a first electrode of the third transistor, the first capacitor electrode of the third capacitor, and the gate electrode of the ninth transistor.

In some embodiments of the present disclosure, the method further comprises providing a same signal to a first electrode of the third transistor, the first capacitor electrode of the third capacitor, and the gate electrode of the tenth transistor.

In some embodiments of the present disclosure, the respective shift register further includes an eighth transistor coupled between the first node and an output terminal; wherein the method further comprises providing a same signal to a first electrode of the third transistor, and a gate electrode of the eighth transistor.

### BRIEF DESCRIPTION OF THE FIGURES

The following drawings are merely examples for illustrative purposes according to various disclosed embodiments and are not intended to limit the scope of the present invention.
FIG. 1 is a plan view of a display panel in some embodiments according to the present disclosure.
FIG. 2 is a schematic diagram of a display apparatus in some embodiments according to the present disclosure.
FIG. 3 is a circuit diagram illustrating the structure of a pixel driving circuit in some embodiments according to the present disclosure.
FIG. 4 is a schematic diagram of a respective shift register in some embodiments according to the present disclosure.
FIG. 5 is a schematic diagram of a respective shift register in some embodiments according to the present disclosure.
FIG. 6 is a schematic diagram of a respective shift register in some embodiments according to the present disclosure.
FIG. 7 is a schematic diagram of a respective shift register in some embodiments according to the present disclosure.
FIG. 8 is a schematic diagram of a respective shift register in some embodiments according to the present disclosure.
FIG. 9 is a timing diagram illustrating the operation of a shift register in some embodiments according to the present disclosure.
FIG. 10 is a schematic diagram of a respective shift register in some embodiments according to the present disclosure.
FIG. 11 is a timing diagram illustrating the operation of a shift register in some embodiments according to the present disclosure.
FIG. 12 is a schematic diagram of a respective shift register in some embodiments according to the present disclosure.
FIG. 13 is a schematic diagram of a respective shift register in some embodiments according to the present disclosure.
FIG. 14 is a schematic diagram of a respective shift register in some embodiments according to the present disclosure.
FIG. 15 is a schematic diagram of a respective shift register in some embodiments according to the present disclosure.
FIG. 16 is a schematic diagram of a scan circuit in some embodiments according to the present disclosure.
FIG. 17 is a schematic diagram of a scan circuit in some embodiments according to the present disclosure.
FIG. 18 is a schematic diagram of a scan circuit in some embodiments according to the present disclosure.

### DETAILED DESCRIPTION

The disclosure will now be described more specifically with reference to the following embodiments. It is to be noted that the following descriptions of some embodiments are presented herein for purpose of illustration and description only. It is not intended to be exhaustive or to be limited to the precise form disclosed.

The present disclosure provides, *inter alia*, a shift register and a method of driving the same, a scan circuit, and a display apparatus that substantially obviate one or more of the problems due to limitations and disadvantages of the related art. In one aspect, the present disclosure provides a shift register. In some embodiments, the scan circuit includes a plurality of cascaded shift registers. In some embodiments, a respective shift register of the plurality of cascaded shift registers comprises a first transistor coupled between an input terminal and a first node; at least four transistors coupled between the first node and a second node in series, wherein the at least four transistors comprise a second transistor, a tenth transistor, a sixth transistor, and a ninth transistor; a fourth transistor coupled between the second node and an output terminal; and a fifth transistor coupled between the first node and the output terminal. Optionally, a gate electrode of the tenth transistor is controlled by a signal that is at least partially in phase with respect to an effective voltage of a signal input to the input terminal. Optionally, a gate electrode of the first transistor is controlled by a signal that is at least partially in phase with respect to the effective voltage of the signal input to the input terminal. Optionally, a gate electrode of the ninth transistor is controlled by a signal that is out of phase with respect to the effective voltage of the signal input to the input terminal.

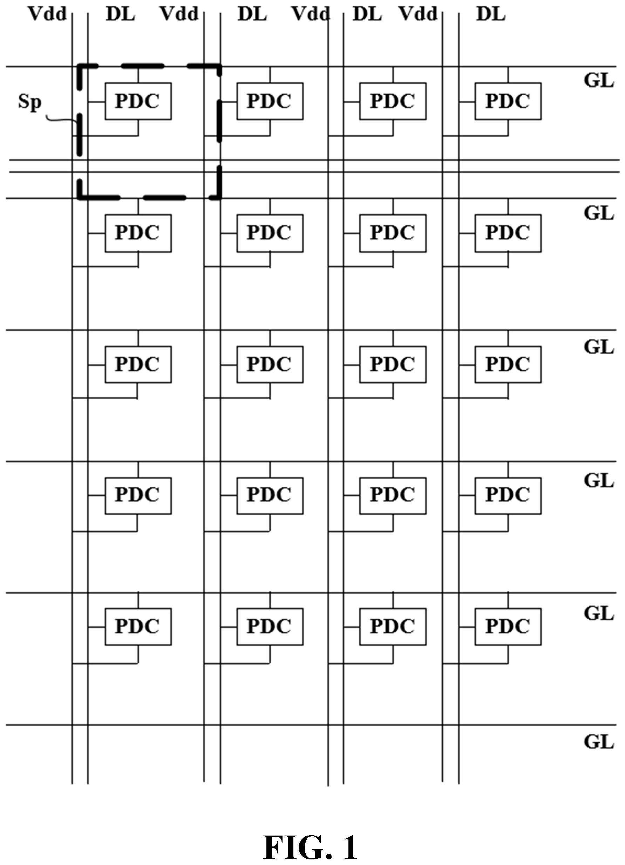

The scan circuit in some embodiments is configured to provide control signals to rows of subpixels in a display panel. Examples of control signals include gate scanning signals, reset control signals, and light emitting control signals. In one example, the control signals are output to pixel driving circuits of a light emitting diode display panel. FIG. 1 is a plan view of a display panel in some embodiments according to the present disclosure. Referring to FIG. 1, the array substrate includes an array of subpixels Sp. Each subpixel includes an electronic component, e.g., a light emitting element. In one example, the light emitting element is driven by a respective pixel driving circuit PDC. The array substrate includes a plurality of gate lines GL, a plurality of data lines DL, and a plurality of high voltage signal lines Vdd. Light emission in a respective subpixel is driven by a respective pixel driving circuit PDC. In one example, a high voltage signal is input, through a respective one of the plurality of high voltage signal lines Vdd, to the respective pixel driving circuit PDC connected to an anode of the light emitting element; a low voltage signal is input to a cathode of the light emitting element. A voltage difference between the high voltage signal (e.g., the VDD signal) and the low voltage signal (e.g., the VSS signal) is a driving voltage ΔV that drives light emission in the light emitting element.

Various appropriate pixel driving circuits may be used in the present array substrate. Examples of appropriate driving circuits include 3T1C, 2T1C, 4T1C, 4T2C, 5T2C, 6T1C, 7T1C, 7T2C, 8T1C, and 8T2C. In some embodiments, the respective one of the plurality of pixel driving circuits is a 7T1C driving circuit. Various appropriate light emitting elements may be used in the present array substrate. Examples of appropriate light emitting elements include organic light emitting diodes, quantum dots light emitting diodes, and micro light emitting diodes. Optionally, the light emitting element is micro light emitting diode. Optionally, the light emitting element is an organic light emitting diode including an organic light emitting layer.

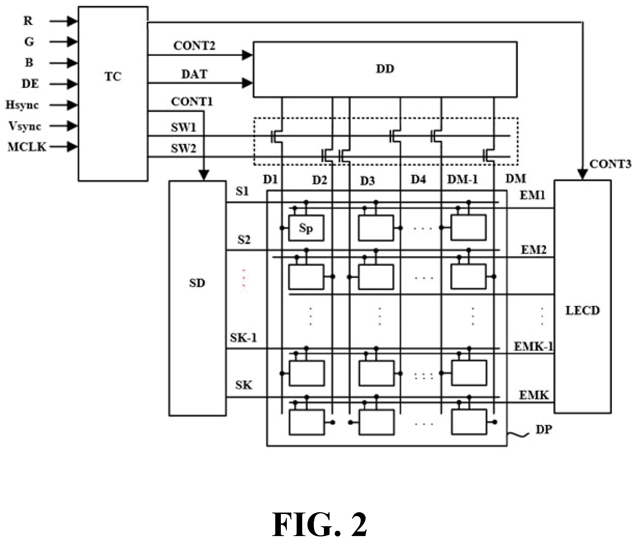

FIG. 2 is a schematic diagram of a display apparatus in some embodiments according to the present disclosure. Referring to FIG. 2, the display apparatus includes a timing controller TC, a scanning driver SD, a data driver DD, a light-emitting control driver LECD, and a display panel DP. The timing controller TC receives synchronization signals and video signals R, G, and B from a system interface. The synchronization signals may include, for example, a horizontal synchronization signal Hsync, a vertical synchronization signal Vsync, a main clock signal MCLK, and a data enabling signal DE. The video signals R, G, and B comprise luminance information of each of a plurality of subpixels Sp. The data enabling signal DE is configured to control a timing of data output by a data line.

The timing controller TC generates a first driving control signal CONT1, a second driving control signal CONT2, a third driving control signal CONT3, a first switch control signal SW1, a second switch control signal SW2, and a digital image signal DAT according to the video signals R, G, and B, the horizontal synchronization signal Hsync, the vertical synchronization signal Vsync, the data enabling signal DE, and the main clock signal MCLK. The timing controller TC also divides the video signals R, G, and B in units of frames according to the vertical synchronization signal Vsync, and divides the video signals R, G, and B in units of data lines according to the horizontal synchronization signal Hsync, to generate a digital image signal DAT. The timing controller TC transmits the digital image signal DAT and the second driving control signal CONT2 to the data driver DD.

The timing controller TC may be implemented in various appropriate ways (for example, using dedicated hardware), to perform various functions discussed herein. A "processor" is an example of the timing controller which uses one or more microprocessors that may be programmed using software (for example, microcodes) to perform the various functions discussed herein. The timing controller TC may be implemented with or without a processor, and may also be implemented as a combination of dedicated hardware which performs some functions and a processor which performs other functions (for example, one or more programmed microprocessors and associated circuits). Examples of controller components which may be used in various embodiments of the present disclosure comprise, but not limited to, conventional microprocessors, Application Specific Integrated Circuits (ASICs), and Field Programmable Gate Arrays (FPGAs).

As shown in FIG. 2, the display panel DP in some embodiments includes a plurality of subpixels Sp which are arranged substantially in a matrix form. In the present embodiment, each of the plurality of subpixels Sp may include a light emitting element such as an organic light emitting diode and its associated pixel driving circuit.

In the display panel DP, a plurality of scanning lines S1, S2, . . . , SK-1, and SK which are substantially parallel extend in a row direction, a plurality of light-emitting control lines EM1, EM2, . . . , EMK-1, EMK which are substantially parallel extend in the row direction, and a plurality of data lines D1, D2, D3, D4 . . . , DM-1, DM which are substantially parallel extend in a column direction. The scanning lines S1 to SK, the light-emitting control lines EM1 to EMK, and the data lines D1 to DM are coupled to the plurality of subpixels Sp. When a light-emitting control signal on a light-emitting control line is valid, a row of subpixels connected to the light-emitting control line is enabled to emit light.

The scanning driver SD is coupled to the scanning lines S1 to SK, and generates a plurality of scanning signals according to the first driving control signal CONT1. The scanning driver SD may sequentially apply a scanning signal to the scanning lines S1 to SK. In some embodiments, the scanning driver SD may be integrated as a Gate Driver On Array (GOA) with the display panel DP.

The light-emitting control driver LECD is coupled to the light-emitting control lines EM1 to EMK, and generates a plurality of light-emitting control signals according to the third driving control signal CONT3. The light-emitting control driver LECD may sequentially apply a light-emitting control signal to the light-emitting control lines EM1 to EMK. In some embodiments, the light-emitting control driver LECD may be integrated as a GOA with the display panel DP.

The data driver DD samples and holds the digital image signal DAT according to the second driving control signal CONT2, and generates a plurality of analog data signals from the digital image signal DAT. In some exemplary embodiments, the data driver DD may comprise a shift register, a latch, a digital-to-analog converter, and a buffer. The shift register may output a latch pulse to the latch. The latch may temporarily store and output the digital image signal DAT, and may output the digital image signal DAT to the digital-to-analog converter. The digital-to-analog converter may generate analog data signals based on the digital image signal DAT, and output the analog data signals to the buffer.

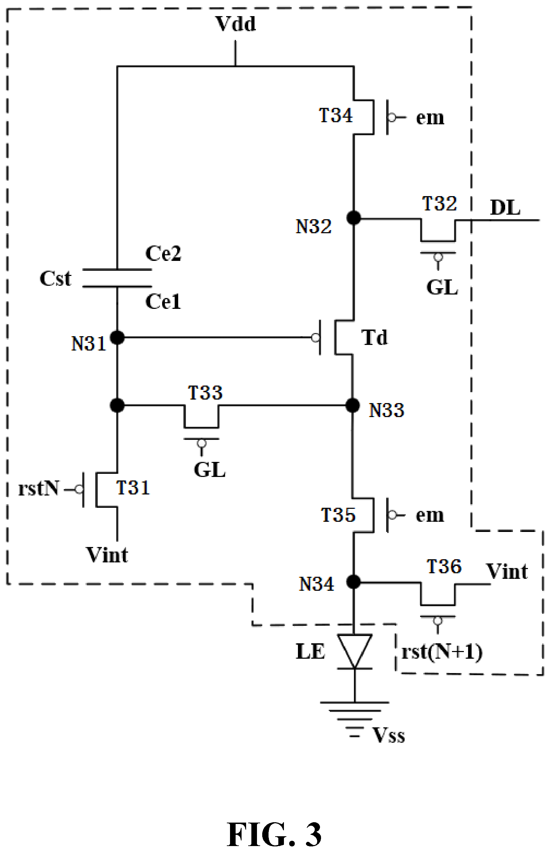

FIG. 3 is a circuit diagram illustrating the structure of a pixel driving circuit in some embodiments according to the present disclosure. Referring to FIG. 3, in some embodiments, the respective pixel driving circuit includes a driving transistor Td; a storage capacitor Cst having a first capacitor electrode Ce1 and a second capacitor electrode Ce2; a first transistor T31 having a gate electrode connected to a respective reset control signal line rstN in a present stage of a plurality of reset control signal lines, a source electrode connected to a respective reset signal line Vint in a present stage of a plurality of first reset signal lines (at the lower left side of FIG. 3), and a drain electrode connected to a first capacitor electrode Ce1 of the storage capacitor Cst and a gate electrode of the driving transistor Td; a second transistor T32 having a gate electrode connected to a respective gate line of a plurality of gate lines GL, a source electrode connected to a respective data line of a plurality of data lines DL, and a drain electrode connected to a source electrode of the driving transistor Td; a third transistor T33 having a gate electrode connected to the respective gate line, a source electrode connected to the first capacitor electrode Ce1 of the storage capacitor Cst and the gate electrode of the driving transistor Td, and a drain electrode connected to a drain electrode of the driving transistor Td; a fourth transistor T34 having a gate electrode connected to a respective light emitting control signal line of a plurality of light emitting control signal lines em, a source electrode connected to a respective voltage supply line of a plurality of voltage supply lines Vdd, and a drain electrode connected to the source electrode of the driving transistor Td and the drain electrode of the second transistor T32; a fifth transistor T35 having a gate electrode connected to the respective light emitting control signal line, a source electrode connected to drain electrodes of the driving transistor Td and the third transistor T33, and a drain electrode connected to an anode of a light emitting element LE; and a sixth transistor T36 having a gate electrode connected to a respective reset control signal line rst(N+1) in a next adjacent stage of a plurality of reset control signal lines, a source electrode connected to a respective reset signal line Vint in the present stage of the plurality of second reset signal lines (Vint at the right side of FIG. 3), and a drain electrode connected to the drain electrode of the fifth transistor and the anode of the light emitting element LE. The second capacitor electrode Ce2 is connected to the respective voltage supply line and the source electrode of the fourth transistor T34.

The pixel driving circuit further includes a first node N31, a second node N32, a third node N33, and a fourth node N34. The first node N31 is connected to the gate electrode of the driving transistor Td, the first capacitor electrode Ce1, and the source electrode of the third transistor T33. The second node N32 is connected to the drain electrode of the fourth transistor T34, the drain electrode of the second transistor T32, and the source electrode of the driving transistor Td. The third node N33 is connected to the drain electrode of the driving transistor Td, the drain electrode of the third transistor T33, and the source electrode of the fifth transistor T35. The fourth node N34 is connected to the drain electrode of the fifth transistor T35, the drain electrode of the sixth transistor T36, and the anode of the light emitting element LE.

In one example, the scan circuit is a gate scanning signal scan circuit configured to provide gate scanning signals to the plurality of gate lines GL. In another example, the scan circuit is a light emitting control signal scan circuit configured to provide light emitting control signals to the plurality of light emitting control signal lines em. In another example, the scan circuit is a reset control signal scan circuit configured to provide reset control signals to the plurality of reset control signal lines (e.g., rstN and rst(N+1)).

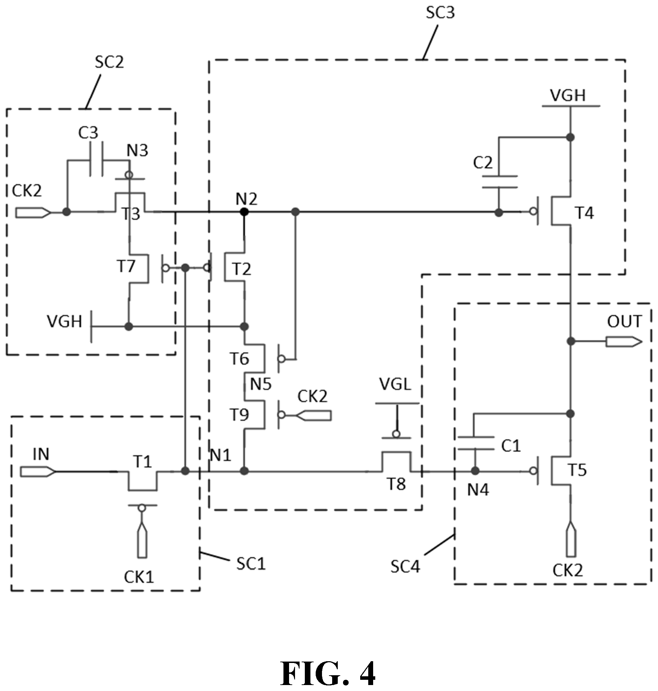

FIG. 4 is a schematic diagram of a respective shift register in a scan circuit in some embodiments according to the present disclosure. Referring to FIG. 4, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a shift register in a different stage (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3, and coupled to a second electrode of the seventh transistor T7. A first electrode of the third transistor T3 is coupled to a second clock signal terminal CK2. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3.

A first capacitor electrode of the third capacitor C3 is coupled to a second clock signal terminal CK2. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, and a second capacitor C2.

A gate electrode of the second transistor T2 is coupled to the first node N1. A first electrode of the second transistor T2 is configured to be provided with a second power supply signal VGH. A second electrode of the second transistor T2 is coupled to the second node N2.

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a second clock signal terminal CK2. A first electrode of the ninth transistor T9 is coupled to the fifth node N5. A second electrode of the ninth transistor T9 is coupled to the first node N1.

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the second clock signal terminal CK2. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

When the fifth transistor T5 depicted in FIG. 4 may present an issue, particularly in medium to large size display panels, the larger size of the fifth transistor T5 will accordingly increase the gate leakage and gate leakage capacitance of the fifth transistor T5. The inventors of the present disclosure discover that, when a second clock signal provided through the second clock signal terminal CK2 jumps from a high level to a low level, the coupling of the gate leakage and gate leakage capacitance of the fifth transistor T5 to the fourth node N4 causes the fourth node N4 to be pulled down by the second clock signal transition, simultaneously pulling down the first node N1 and the fifth node N5. The pulling down of the first node N1 causes the second transistor T2 and the seventh transistor T7 to turn on, and the second node N2 and the third node N3 to be pulled up by the second power supply signal VGH, thus preventing the third transistor T3, the fourth transistor T4, and the sixth transistor T6 from turning on. This forms negative feedback in the shift register, leading to circuit failure. When a high-level output is needed, the fifth transistor T5 frequently turns on, resulting in a low-level output.

Therefore, the present disclosure provides a shift register according to the present disclosure which can obviate the issue identified herein. The shift register can obviate the impact of voltage fluctuations at the gate of the fifth transistor T5, for example caused by the second clock signal from the second clock signal terminal CK2 jumping from the high level to the low level, which leads to instability of the shift register. The shift register according to the present disclosure can, unexpectedly and surprisingly, enhances the circuit's stability and improves its adaptability under harsh environmental conditions.

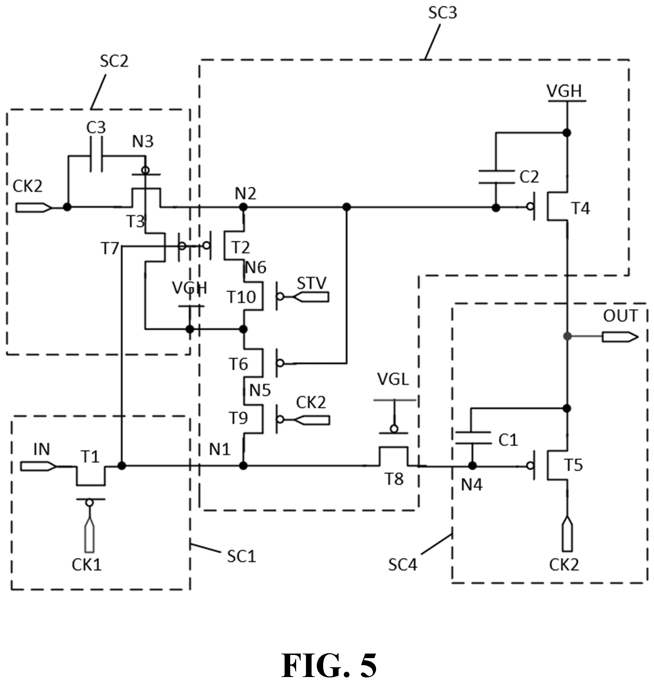

FIG. 5 is a schematic diagram of a respective shift register in some embodiments according to the present disclosure. Referring to FIG. 5, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a second clock signal terminal CK2. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3.

A first capacitor electrode of the third capacitor C3 is coupled to a second clock signal terminal CK2. A second capacitor electrode of the third capacitor C3 is coupled to the gate electrode of the third transistor T3, and coupled to the second electrode of the seventh transistor T7. The first clock signal terminal CK1 and the second clock signal terminal CK2 are configured to receive different clock signals, e.g., a first clock signal and a second clock signal, respectively. In one example, the first clock signal and the second clock signal are out of phase.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is coupled to a second electrode of the tenth transistor T10. A second electrode of the second transistor T2 is coupled to the second node N2.

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a second clock signal terminal CK2. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to a start signal terminal STV (or configured to receive an output signal from an output terminal of a shift register in a different stage). A first electrode of the tenth transistor T10 is configured to be provided with a second power supply signal VGH. A second electrode of the tenth transistor T10 is coupled to the first electrode of the second transistor T2 (a sixth node N6).

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the second clock signal terminal CK2. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

The scan circuit depicted in FIG. 5 according to the above embodiments of the present disclosure can obviate the impact of voltage fluctuations at the gate of the fifth transistor T5, caused by the second clock signal from the second clock signal terminal CK2 jumping from the high level to the low level, which leads to instability of the shift register. The inventors of the present disclosure discover that the shift register depicted in FIG. 5 can, unexpectedly and surprisingly, enhances the circuit's stability and improves its adaptability under harsh environmental conditions.

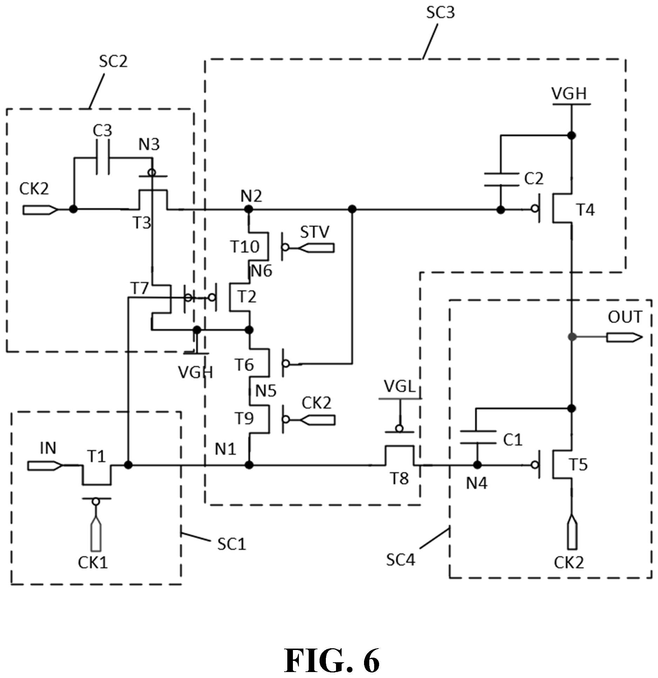

FIG. 6 is a schematic diagram of a respective shift register in some embodiments according to the present disclosure. Referring to FIG. 6, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a second clock signal terminal CK2. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3 (e.g., the third node N3).

A first capacitor electrode of the third capacitor C3 is coupled to a second clock signal terminal CK2. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is configured to be provided with a second power supply signal VGH. A second electrode of the second transistor T2 is coupled to a first electrode of the tenth transistor T10 (e.g., a sixth node N6).

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a second clock signal terminal CK2. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to a start signal terminal STV (or configured to receive an output signal from an output terminal of a shift register in a different stage). A first electrode of the tenth transistor T10 is coupled to the second electrode of the second transistor T2 (e.g., the sixth node N6). A second electrode of the tenth transistor T10 is coupled to the second node N2.

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the second clock signal terminal CK2. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

The shift register depicted in FIG. 6 according to the above embodiments of the present disclosure can obviate the impact of voltage fluctuations at the gate of the fifth transistor T5, caused by the second clock signal from the second clock signal terminal CK2 jumping from the high level to the low level, which leads to circuit instability. The inventors of the present disclosure discover that the shift register depicted in FIG. 6 can, unexpectedly and surprisingly, enhances the circuit's stability and improves its adaptability under harsh environmental conditions.

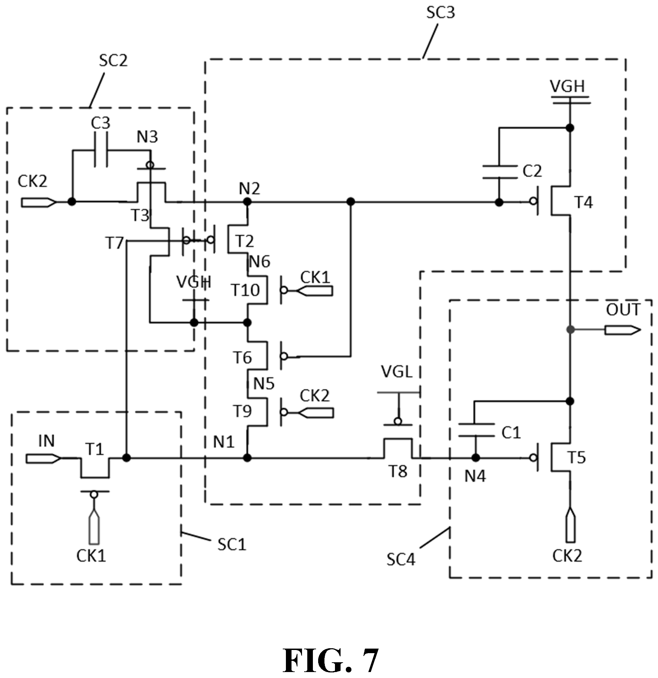

FIG. 7 is a schematic diagram of a respective shift register in a scan circuit in some embodiments according to the present disclosure. Referring to FIG. 7, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a second clock signal terminal CK2. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3.

A first capacitor electrode of the third capacitor C3 is coupled to a second clock signal terminal CK2. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is coupled to a second electrode of the tenth transistor T10. A second electrode of the second transistor T2 is coupled to the second node N2.

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a second clock signal terminal CK2. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to a first clock signal terminal CK1. A first electrode of the tenth transistor T10 is configured to be provided with a second power supply signal VGH. A second electrode of the tenth transistor T10 is coupled to the first electrode of the second transistor T2 (a sixth node N6).

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the second clock signal terminal CK2. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

The shift register depicted in FIG. 7 according to the above embodiments of the present disclosure can obviate the impact of voltage fluctuations at the gate of the fifth transistor T5, caused by the second clock signal from the second clock signal terminal CK2 jumping from the high level to the low level, which leads to circuit instability. The inventors of the present disclosure discover that the shift register depicted in FIG. 7 can, unexpectedly and surprisingly, enhances the circuit's stability and improves its adaptability under harsh environmental conditions.

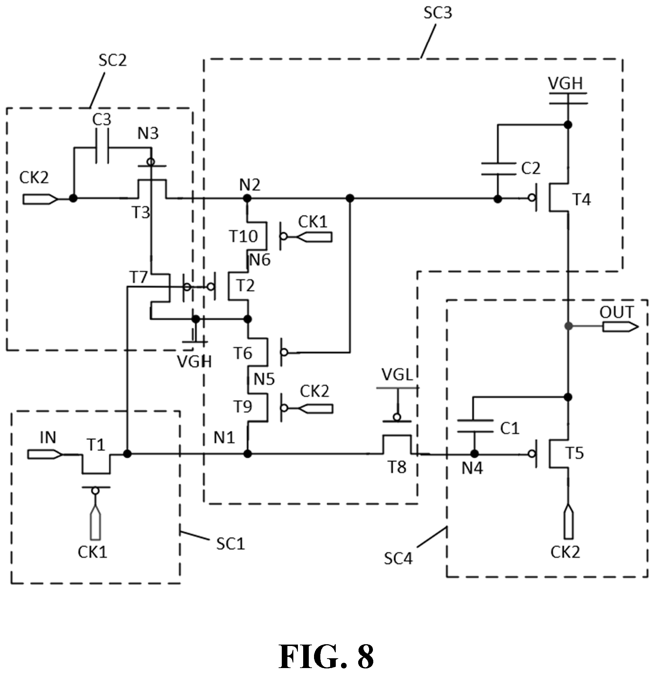

FIG. 8 is a schematic diagram of a respective shift register in some embodiments according to the present disclosure. Referring to FIG. 8, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a second clock signal terminal CK2. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3 (e.g., the third node N3).

A first capacitor electrode of the third capacitor C3 is coupled to a second clock signal terminal CK2. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is configured to be provided with a second power supply signal VGH. A second electrode of the second transistor T2 is coupled to a first electrode of the tenth transistor T10 (e.g., a sixth node N6).

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a second clock signal terminal CK2. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to a first clock signal terminal CK1. A first electrode of the tenth transistor T10 is coupled to the second electrode of the second transistor T2 (e.g., the sixth node N6). A second electrode of the tenth transistor T10 is coupled to the second node N2.

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the second clock signal terminal CK2. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

The shift register depicted in FIG. 8 according to the above embodiments of the present disclosure can obviate the impact of voltage fluctuations at the gate of the fifth transistor T5, caused by the second clock signal from the second clock signal terminal CK2 jumping from the high level to the low level, which leads to circuit instability. The inventors of the present disclosure discover that the shift register depicted in FIG. 8 can, unexpectedly and surprisingly, enhances the circuit's stability and improves its adaptability under harsh environmental conditions.

The present disclosure may be implemented in shift registers having transistors of various types, including a shifter register having p-type transistors, a shift register having n-type transistors, or a shift register having one or more p-type transistors and one or more n-type transistors. For a p-type transistor, an effective control signal (e.g., a turn-on control signal) is a low level signal, and an ineffective control signal (e.g., a turn-off control signal) is a high level signal. For an n-type transistor, an effective control signal (e.g., a turn-on control signal) is a high level signal, and an ineffective control signal (e.g., a turn-off control signal) is a low level signal. In one example, the first transistor T1 to the tenth transistor T10 may be a P-type transistor such as a polysilicon transistor. In one example, the first transistor T1 to the tenth transistor T10 may be an N-type transistor such as a metal oxide transistor.

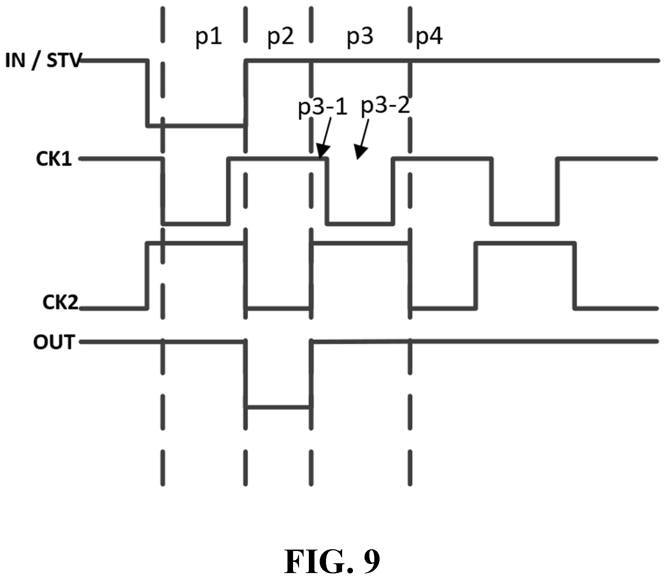

FIG. 9 is a timing diagram illustrating the operation of a shift register in some embodiments according to the present disclosure. FIG. 9 may be a timing diagram illustrating the operation of a shift register depicted in any one of FIG. 5 to FIG. 8. Referring to FIG. 9, the operation of the respective shift register in a frame of image includes a first period p1, a second period p2, a third period p3, and a fourth period p4.

In the first period p1, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a low level. The second clock signal received through the second clock signal terminal CK2 is at a high level.

In the first period p1, the first transistor T1 is turned on, the low level of the signal received through the input terminal IN sets the first node N1 and the fourth node N4 to low levels, and charges the first capacitor C1. The eighth transistor T8 is turned on.

In the first period p1, the low level received through the start signal terminal STV or the low level received through the first clock signal terminal CK1 turns on the tenth transistor T10. In one example, a time point when the low level received through the start signal terminal STV is received by the start signal terminal STV is prior to a time point when the low level received through the first clock signal terminal CK1 is received by the first clock signal terminal CK1.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the second transistor T2 and the tenth transistor T10 are turned on. The second node N2 is charged with the second power supply signal VGH, which is at a high level. The high level at the second node N2 charges the second capacitor C2, and turns off the fourth transistor T4.

In the first period p1, the fourth node N4 is at a low level, and the fifth transistor T5 is turned on. The second clock signal is at a high level. The second clock signal passes through the fifth transistor T5, and the output terminal OUT outputs a high level signal.

In the second period p2, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a low level.

In the second period p2, the first transistor T1 is turned off, the first node N1 maintains a low level due to absence of a discharging path. The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

In the second period p2, the high level received through the start signal terminal STV or the high level received through the first clock signal terminal CK1 turns off the tenth transistor T10.

In the second period p2, the third transistor T3 remains turned off, the tenth transistor T10 is turned off. The second node N2 maintains a high level. The high level at the second node N2 turns off the sixth transistor T6 and the fourth transistor T4.

In the second period p2, the first node N1 maintains a low level, the eighth transistor T8 is turned on, and the fourth node N4 also maintains a low level. The low level at the fourth node N4 turns on the fifth transistor T5. The second clock signal is at a low level. The second clock signal passes through the fifth transistor T5, and the output terminal OUT outputs a low level signal.

In the third period p3, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 switches from a high level to a low level, and then switches from a low level to a high level. The second clock signal received through the second clock signal terminal CK2 is at a high level. That is, in the third period p3, the duration in which the second clock signal is at a high level is larger than the duration in which the first clock signal is at a low level. In other words, once the second clock signal enters into the third period p3, the second clock signal switches from the low level to the high level, and the first clock signal switches slightly later than the second clock signal.

As shown in FIG. 9, in the third period p3, after the first clock signal enters into the third period p3, the first clock signal switches from the high level to the low level only at p3-1, and only is at the low level during p3-2.

Before the first clock signal transitions from the high level to the low level (as denoted as p3-1 in FIG. 9), the potentials at the first node N1 and the fourth node N4 remain at low levels as in the second period p2. Before the first clock signal transitions from the high level to the low level, the fifth transistor T5 remains turned on, and the output terminal OUT outputs a high level of the second clock signal.

After the first clock signal transitions from the high level to the low level (as denoted as p3-2 in FIG. 9), the first transistor T1 is turned on, pulling the potentials at the first node N1 and the fourth node N4 to high levels. The high level at the fourth node N4 turns off the fifth transistor T5, thereby resetting the respective shift register. The high level at the first node N1 turns off the second transistor T2 and the seventh transistor T7, thereby setting the gate electrode of the third transistor T3 in a floating state. The second clock signal received through the second clock signal terminal CK2 is at a high level. Due to the capacitor effect of the third capacitor C3, the gate electrode of the third transistor T4 maintains at a high level. The third transistor T3 remains turned off. In one example, a capacitance of the third capacitor C3 is greater than a capacitance of the first capacitor C1, and is greater than a capacitance of the second capacitor C2.

In the third period p3, the second transistor T2 and the third transistor T3 are turned off, the second node N2 maintains a high level. The high level at the second node N2 turns off the sixth transistor T6 and the fourth transistor T4.

In the third period p3, the sixth transistor T6, the fourth transistor T4, and the fifth transistor T5 are turned off. The output terminal OUT maintains a high level.

In the fourth period p4, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level, and then switches from the high level to the low level for a first duration and then switches to the high level again. The second clock signal received through the second clock signal terminal CK2 is at a low level, and then switches from the low level to the high level for a second duration and then switches to the low level again. In the fourth period, the first duration of the first clock signal being at the low level overlaps with the second duration of the second clock signal being at the high level, and the first duration is smaller than the second duration.

In the fourth period p4, the high level received through the start signal terminal STV or the high level received through the first clock signal terminal CK1 turns off the tenth transistor T10.

In the fourth period p4, the first transistor T1 is turned off, the first node N1 maintains a high level due to absence of a discharging path. The high level at the first node N1 turns off the second transistor T2 and the seventh transistor T7, thereby setting the gate electrode of the third transistor T3 in a floating state.

In the fourth period p4, the second clock signal is at a low level first, then transitions into a high level. Due to the coupling of the third capacitor C3, the potential at the gate electrode of the third transistor T3 is at a low level first, then transitions into a high level. The third transistor T3 turns on first, then turns off. The potential at the second node N2 is at a low level first, then the second node N2 floats, and the potential at the second node N2 remains at a low level. The low level at the second node N2 turns on the fourth transistor T4 and the sixth transistor T6. The second power supply signal VGH passes through the fourth transistor T4, the output terminal OUT outputs the second power supply signal VGH.

The sixth transistor T6 and the ninth transistor T9 are turned on, the second power supply signal VGH passes through the sixth transistor T6 and the ninth transistor T9, setting the potential at the first node N1 to a high level.

The eighth transistor T8 is turned on. The high level at the first node N1 sets the potential at the fourth node N4 to a high level, turning off the fifth transistor T5. The output terminal OUT maintains a high level.

In the shift register of the present disclosure, the tenth transistor T10 stabilizes the potential at the second node N2 when the second clock signal transitions between the high level and the low level.

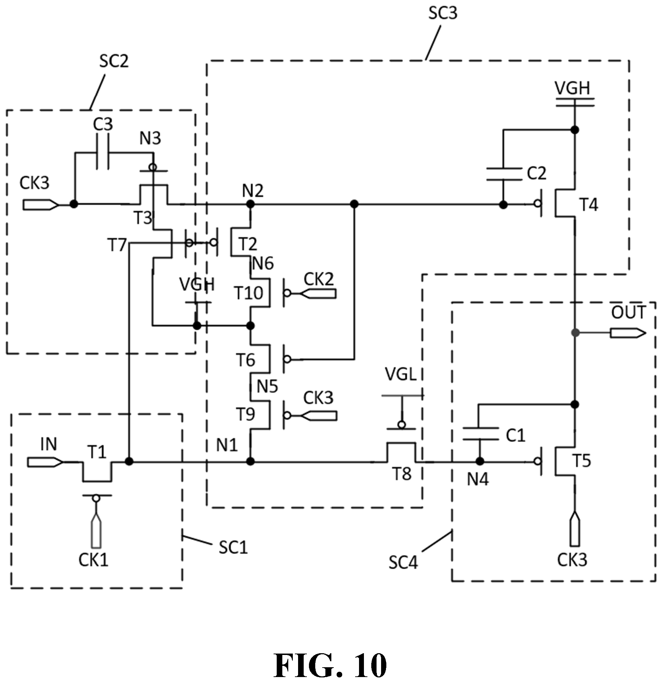

FIG. 10 is a schematic diagram of a respective shift register in a scan circuit in some embodiments according to the present disclosure. Referring to FIG. 10, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a third clock signal terminal CK3. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3.

A first capacitor electrode of the third capacitor C3 is coupled to a third clock signal terminal CK3. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is coupled to a second electrode of the tenth transistor T10. A second electrode of the second transistor T2 is coupled to the second node N2.

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to the third clock signal terminal CK3. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to a second clock signal terminal CK2. A first electrode of the tenth transistor T10 is configured to be provided with a second power supply signal VGH. A second electrode of the tenth transistor T10 is coupled to the first electrode of the second transistor T2 (a sixth node N6).

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the third clock signal terminal CK3. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

In some embodiments, the first clock signal terminal CK1, the second clock signal terminal CK2, and the third clock signal terminal CK3 are configured to receive different clock signals. Optionally, the first clock signal terminal CK1, the second clock signal terminal CK2, and the third clock signal terminal CK3 are configured to receive different clock signals that are out of phase with respect to each other.

In some embodiments, the first clock signal terminal CK1, the second clock signal terminal CK2, and the third clock signal terminal CK3 are configured to receive three different clock signals selected from N number of clock signals that are out of phase with respect to each other, wherein N > 3. Optionally, the N number of clock signals are phase-shifted relative to one another and are sequentially clocked in a systematic manner. In some embodiments, the clock signals received by the first clock signal terminal CK1, the second clock signal terminal CK2, and the third clock signal terminal CK3, respectively, are phase-shifted relative to one another and are sequentially clocked in a systematic manner.

In one example, the first clock signal terminal CK1, the second clock signal terminal CK2, and the third clock signal terminal CK3 are configured to receive three different clock signals selected from a first clock signal, a second clock signal, a third clock signal, and a fourth clock signal, wherein the first clock signal, the second clock signal, the third clock signal, and the fourth clock signal are out of phase with respect to each other. In another example, the first clock signal, the second clock signal, the third clock signal, and the fourth clock signal are phase-shifted relative to one another and are sequentially clocked in a systematic manner.

The inventors of the present disclosure discover that the shift register depicted in FIG. 10 can obviate the impact of voltage fluctuations at the gate of the fifth transistor T5, caused by the third clock signal from the third clock signal terminal CK3 jumping from the high level to the low level, which leads to circuit instability. The inventors of the present disclosure discover that the shift register depicted in FIG. 10 can, unexpectedly and surprisingly, enhances the circuit's stability and improves its adaptability under harsh environmental conditions.

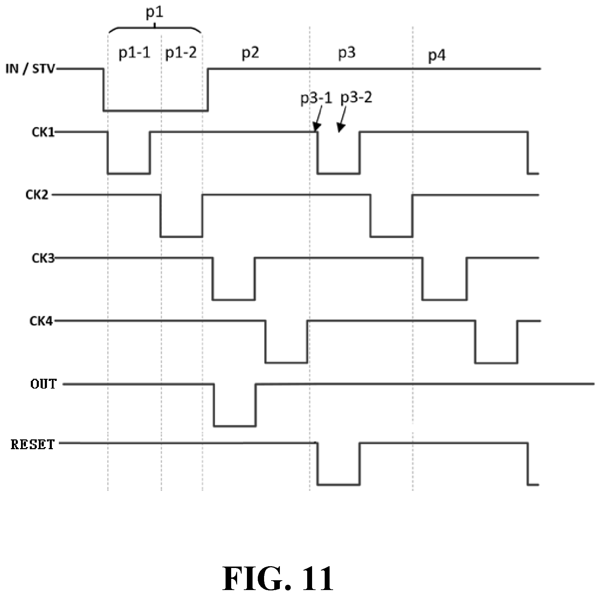

FIG. 11 is a timing diagram illustrating the operation of a shift register in some embodiments according to the present disclosure. FIG. 11 may be a timing diagram illustrating the operation of a shift register depicted in any one of FIG. 10. Referring to FIG. 11, the operation of the respective shift register in a frame of image includes a first period p1, a second period p2, a third period p3, and a fourth period p4. In some embodiments, the first period p1 may include a first subperiod p1-1 and a second subperiod p1-2. In some embodiments, the first clock signal terminal CK1, the second clock signal terminal CK2, and the third clock signal terminal CK3 are configured to receive three different clock signals selected from a first clock signal provided by a first clock signal line, a second clock signal provided by a second clock signal line, a third clock signal provided by a third clock signal line, and a fourth clock signal provided by a fourth clock signal line, wherein the first clock signal, the second clock signal, the third clock signal, and the fourth clock signal are out of phase with respect to each other. FIG. 11 illustrates a shift register in a stage in which the first clock signal terminal CK1 receives the first clock signal provided by the first clock signal line, the second clock signal terminal CK2 receives the second clock signal provided by the second clock signal line, and the third clock signal terminal CK3 receives the third clock signal provided by the third clock signal line. In one example, the first clock signal, the second clock signal, the third clock signal, and the fourth clock signal are phase-shifted relative to one another and are sequentially clocked in a systematic manner. In other stages, the shift register may receive clock signals of different combinations.

In the first subperiod p1-1, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a low level. The second clock signal received through the second clock signal terminal CK2 is at a high level. The third clock signal received through the third clock signal terminal CK3 is at a high level.

In the first subperiod p1-1, the first transistor T1 is turned on, the low level of the signal received through the input terminal IN sets the first node N1 and the fourth node N4 to low levels, and charges the first capacitor C1. The eighth transistor T8 is turned on.

In the first subperiod p1-1, the high level received through the second clock signal terminal CK2 turns off the tenth transistor T10.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the tenth transistor T10 is turned off. The second node N2 maintains a low level. The low level at the second node N2 turns on the fourth transistor T4, the second power supply signal VGH passes through the fourth transistor T4, and the output terminal OUT outputs a high level signal. The first node N1 is at a low level, the fifth transistor T5 is turned on, and the output terminal OUT outputs a high level signal.

In the second subperiod p1-2, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a high level. The second clock signal received through the second clock signal terminal CK2 is at a low level. The third clock signal received through the third clock signal terminal CK3 is at a high level.

In the second subperiod p1-2, the first clock signal is at a high level, the first transistor T1 is turned off, and the second clock signal is at a low level, the tenth transistor T10 is turned on. The first node N1 and the fourth node N4 maintain low levels.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the second transistor T2 and the tenth transistor T10 are turned on. The second node N2 is charged with the second power supply signal VGH, which is at a high level. The high level at the second node N2 charges the second capacitor C2, and turns off the fourth transistor T4.

In the second subperiod p1-2, the fourth node N4 is at a low level, and the fifth transistor T5 is turned on. The third clock signal is at a high level. The third clock signal passes through the fifth transistor T5, and the output terminal OUT outputs a high level signal.

In the second period p2, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is first at a low level, then transitions into a high level.

In the second period p2, the first transistor T1 is turned off, the first node N1 maintains a low level due to absence of a discharging path. The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

In the second period p2, the high level received through the second clock signal terminal CK2 turns off the tenth transistor T10.

In the second period p2, the third transistor T3 remains turned off, the tenth transistor T10 is turned off. The second node N2 maintains a high level. The high level at the second node N2 turns off the sixth transistor T6.

In the second period p2, the first node N1 maintains a low level, the eighth transistor T8 is turned on, and the fourth node N4 also maintains a low level. The low level at the fourth node N4 turns on the fifth transistor T5. The third clock signal is at a low level. The third clock signal through the fifth transistor T5, and the output terminal OUT outputs a low level signal.

In the third period p3, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is first at a high level and then transitions into a low level lasting for a duration, then transitions into a high level. The second clock signal received through the second clock signal terminal CK2 is first at a high level, then transitions into a low level. The third clock signal received through the third clock signal terminal CK3 is at a high level. As shown in FIG. 11, in the third period p3, after the first clock signal transitions from the low level to the high level, the second clock signal switches from the high level to the low level.

Before the first clock signal transitions from the high level to the low level (as denoted as p3-1 in FIG. 11), the potentials at the first node N1 and the fourth node N4 remain at low levels as in the second period p2. Before the first clock signal transitions from the high level to the low level, the fifth transistor T5 remains turned on, and the output terminal OUT outputs a high level of the third clock signal.

After the first clock signal transitions from the high level to the low level (as denoted as p3-2 in FIG. 11), the first transistor T1 is turned on, pulling the potentials at the first node N1 and the fourth node N4 to high levels. The high level at the fourth node N4 turns off the fifth transistor T5, thereby resetting the respective shift register. The high level at the first node N1 turns off the second transistor T2 and the seventh transistor T7, thereby setting the gate electrode of the third transistor T3 in a floating state. The third transistor T3 remains turned off.

In the third period p3, the second transistor T2 and the third transistor T3 are turned off, the second node N2 maintains a high level. The high level at the second node N2 turns off the sixth transistor T6 and the fourth transistor T4.

In the third period p3, the sixth transistor T6, the fourth transistor T4, and the fifth transistor T5 are turned off. The output terminal OUT maintains a high level.

In the fourth period p4, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is at a low level.

In the fourth period p4, the high level received through the second clock signal terminal CK2 turns off the tenth transistor T10.

In the fourth period p4, the first transistor T1 is turned off, the first node N1 maintains a high level due to absence of a discharging path. The high level at the first node N1 turns off the second transistor T2 and the seventh transistor T7, thereby setting the gate electrode of the third transistor T3 in a floating state.

In the fourth period p4, the third clock signal is at a low level first, then transitions into a high level. Due to the coupling of the third capacitor C3, the potential at the gate electrode of the third transistor T3 is at a low level first, then transitions into a high level. The third transistor T3 turns on first, then turns off. The potential at the second node N2 is at a low level first, then the second node N2 floats, and the potential at the second node N2 remains at a low level. The low level at the second node N2 turns on the fourth transistor T4 and the sixth transistor T6. The second power supply signal VGH passes through the fourth transistor T4, the output terminal OUT outputs the second power supply signal VGH.

The sixth transistor T6 and the ninth transistor T9 are turned on, the second power supply signal VGH passes through the sixth transistor T6 and the ninth transistor T9, setting the potential at the first node N1 to a high level.

The eighth transistor T8 is turned on. The high level at the first node sets the potential at the fourth node N4 to a high level, turning off the fifth transistor T5. The output terminal OUT maintains a high level.

The inventors of the present disclosure discover that the tenth transistor T10 stabilizes the potential at the second node N2 when the third clock signal transitions from between the high level and the low level.

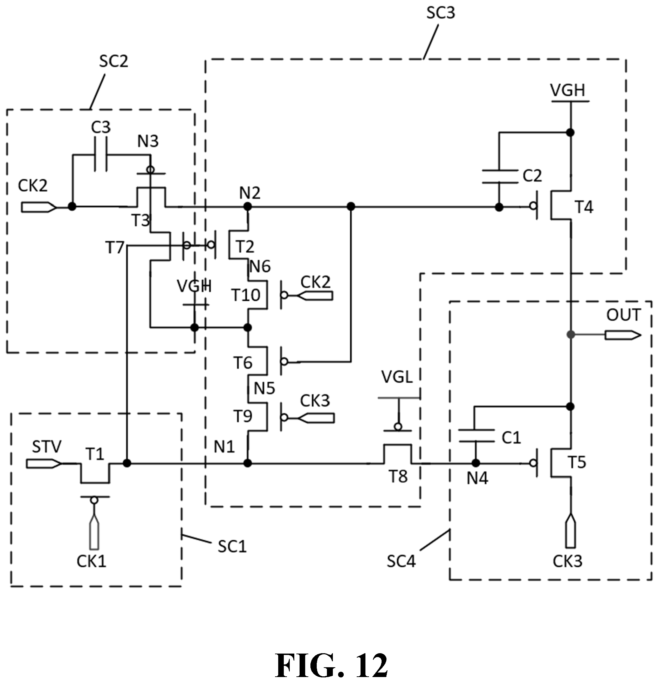

FIG. 12 is a schematic diagram of a respective shift register in some embodiments according to the present disclosure. Referring to FIG. 12, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a second clock signal terminal CK2. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3.

A first capacitor electrode of the third capacitor C3 is coupled to the second clock signal terminal CK2. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is coupled to a second electrode of the tenth transistor T10. A second electrode of the second transistor T2 is coupled to the second node N2.

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a third clock signal terminal CK3. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to the second clock signal terminal CK2. A first electrode of the tenth transistor T10 is configured to be provided with a second power supply signal VGH. A second electrode of the tenth transistor T10 is coupled to the first electrode of the second transistor T2 (a sixth node N6).

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the third clock signal terminal CK3. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

In some embodiments, the first clock signal terminal CK1, the second clock signal terminal CK2, and the third clock signal terminal CK3 are configured to receive different clock signals. Optionally, the first clock signal terminal CK1, the second clock signal terminal CK2, and the third clock signal terminal CK3 are configured to receive different clock signals that are out of phase with respect to each other.

In some embodiments, the first clock signal terminal CK1, the second clock signal terminal CK2, and the third clock signal terminal CK3 are configured to receive three different clock signals selected from N number of clock signals that are out of phase with respect to each other, wherein N > 3. Optionally, the N number of clock signals are phase-shifted relative to one another and are sequentially clocked in a systematic manner. In some embodiments, the clock signals received by the first clock signal terminal CK1, the second clock signal terminal CK2, and the third clock signal terminal CK3, respectively, are phase-shifted relative to one another and are sequentially clocked in a systematic manner.

In one example, the first clock signal terminal CK1, the second clock signal terminal CK2, and the third clock signal terminal CK3 are configured to receive three different clock signals selected from a first clock signal, a second clock signal, a third clock signal, and a fourth clock signal, wherein the first clock signal, the second clock signal, the third clock signal, and the fourth clock signal are out of phase with respect to each other. In another example, the first clock signal, the second clock signal, the third clock signal, and the fourth clock signal are phase-shifted relative to one another and are sequentially clocked in a systematic manner.

The inventors of the present disclosure discover that the shift register depicted in FIG. 12 can obviate the impact of voltage fluctuations at the gate of the fifth transistor T5, caused by the third clock signal from the third clock signal terminal CK3 jumping from the high level to the low level, which leads to circuit instability. The inventors of the present disclosure discover that the shift register depicted in FIG. 12 can, unexpectedly and surprisingly, enhances the circuit's stability and improves its adaptability under harsh environmental conditions.

The shift register depicted in FIG. 12 differs from the shifter register depicted in FIG. 10 in that, in the shift register depicted in FIG. 10, the first capacitor electrode of the third capacitor C3 and the first electrode of the third transistor T3 are coupled to a third clock signal terminal CK3; whereas, in the shift register depicted in FIG. 12, the first capacitor electrode of the third capacitor C3 and the first electrode of the third transistor T3 are coupled to a second clock signal terminal CK2. In the shift register depicted in FIG. 10, the clock signal received by the first capacitor electrode of the third capacitor C3 and the first electrode of the third transistor T3 is the same as the clock signal received by the first electrode of the fifth transistor T5 and the gate electrode of the ninth transistor T9. In the shift register depicted in FIG. 12, the clock signal received by the first capacitor electrode of the third capacitor C3 and the first electrode of the third transistor T3 is the same as the clock signal received by the gate electrode of the tenth transistor T10.

In the shift register depicted in FIG. 12, subsequent to outputting a low level voltage through the output terminal OUT in the respective shift register, and prior to the third clock signal transitioning into a low level voltage, by coupling the first capacitor electrode of the third capacitor C3 and the first electrode of the third transistor T3 to the second clock signal terminal CK2, it can be avoided that the second node N2 still is at a high level prior to the third clock signal transitioning into the low level voltage, that is, the second node N2 is at a low level before the third clock signal transitions to a low level, in order to turn on the sixth transistor T6. The scan circuit depicted in FIG. 12 can avoid the risk of the sixth transistor T6 being unable to turn on and pull up the first node N1, which could compromise the stability of node N1. As compared to the shift register depicted in FIG. 10, the shift register depicted in FIG. 12 has significantly improved circuit stability.

FIG. 11 may be a timing diagram illustrating the operation of a shift register depicted in any one of FIG. 12. Referring to FIG. 11, the operation of the respective shift register in a frame of image includes a first period p1, a second period p2, a third period p3, and a fourth period p4. In some embodiments, the first period p1 may include a first subperiod p1-1 and a second subperiod p1-2. In some embodiments, the first clock signal terminal CK1, the second clock signal terminal CK2, and the third clock signal terminal CK3 are configured to receive three different clock signals selected from a first clock signal provided by a first clock signal line, a second clock signal provided by a second clock signal line, a third clock signal provided by a third clock signal line, and a fourth clock signal provided by a fourth clock signal line, wherein the first clock signal, the second clock signal, the third clock signal, and the fourth clock signal are out of phase with respect to each other. FIG. 11 illustrates a shift register in a stage in which the first clock signal terminal CK1 receives the first clock signal provided by the first clock signal line, the second clock signal terminal CK2 receives the second clock signal provided by the second clock signal line, and the third clock signal terminal CK3 receives the third clock signal provided by the third clock signal line. In one example, the first clock signal, the second clock signal, the third clock signal, and the fourth clock signal are phase-shifted relative to one another and are sequentially clocked in a systematic manner. In other stages, the shift register may receive clock signals of different combinations.

In the first subperiod p1-1, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a low level. The second clock signal received through the second clock signal terminal CK2 is at a high level. The third clock signal received through the third clock signal terminal CK3 is at a high level.

In the first subperiod p1-1, the first transistor T1 is turned on, the low level of the signal received through the input terminal IN sets the first node N1 and the fourth node N4 to low levels, and charges the first capacitor C1. The eighth transistor T8 is turned on.

In the first subperiod p1-1, the high level received through the second clock signal terminal CK2 turns off the tenth transistor T10.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the tenth transistor T10 is turned off. The second node N2 maintains a low level. The low level at the second node N2 turns on the fourth transistor T4, the second power supply signal VGH passes through the fourth transistor T4, and the output terminal OUT outputs a high level signal.

In the second subperiod p1-2, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a high level. The second clock signal received through the second clock signal terminal CK2 is at a low level. The third clock signal received through the third clock signal terminal CK3 is at a high level.

In the second subperiod p1-2, the first transistor T1 is turned off, the tenth transistor T10 is turned on. The first node N1 and the fourth node N4 maintain low levels.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the second transistor T2 and the tenth transistor T10 are turned on. The second node N2 is charged with the second power supply signal VGH, which is at a high level. The high level at the second node N2 charges the second capacitor C2, and turns off the fourth transistor T4.

In the second subperiod p1-2, the fourth node N4 is at a low level, and the fifth transistor T5 is turned on. The third clock signal is at a high level. The third clock signal passes through the fifth transistor T5, and the output terminal OUT outputs a high level signal.

In the second period p2, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is first at a low level, then transitions into a high level.

In the second period p2, the first transistor T1 is turned off, the first node N1 maintains a low level due to absence of a discharging path. The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

In the second period p2, the high level received through the second clock signal terminal CK2 turns off the tenth transistor T10.

In the second period p2, the third transistor T3 remains turned off, the tenth transistor T10 is turned off. The second node N2 maintains a high level. The high level at the second node N2 turns off the sixth transistor T6.

In the second period p2, the first node N1 maintains a low level, the eighth transistor T8 is turned on, and the fourth node N4 also maintains a low level. The low level at the fourth node N4 turns on the fifth transistor T5. The third clock signal is at a low level. The third clock signal through the fifth transistor T5, and the output terminal OUT outputs a low level signal.

In the third period p3, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is first at a low level, then transitions into a high level. The second clock signal received through the second clock signal terminal CK2 is first at a high level, then transitions into a low level. The third clock signal received through the third clock signal terminal CK3 is at a high level.

Before the first clock signal transitions from the high level to the low level (as denoted as p3-1 in FIG. 11), the potentials at the first node N1 and the fourth node N4 remain at low levels as in the second period p2. Before the first clock signal transitions from the high level to the low level, the fifth transistor T5 remains turned on, and the output terminal OUT outputs a high level of the third clock signal.

After the first clock signal transitions from the high level to the low level (as denoted as p3-2 in FIG. 11), the first transistor T1 is turned on, pulling the potentials at the first node N1 and the fourth node N4 to high levels. The high level at the fourth node N4 turns off the fifth transistor T5, thereby resetting the respective shift register. The high level at the first node N1 turns off the second transistor T2 and the seventh transistor T7, thereby setting the gate electrode of the third transistor T3 in a floating state. The third transistor T3 remains turned off.

In the third period p3, subsequent to the second clock signal transitioning into a low level, the third transistor T3 is turned on. The low level provided by the second clock signal lowers the potential at the second node N2 to a low level, turning on the fourth transistor T4 and the sixth transistor T6. The output terminal OUT outputs a high level.

In the fourth period p4, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is at a low level.

In the fourth period p4, the high level received through the second clock signal terminal CK2 turns off the tenth transistor T10.

In the fourth period p4, the first transistor T1 is turned off, the first node N1 maintains a high level due to absence of a discharging path. The high level at the first node N1 turns off the second transistor T2 and the seventh transistor T7, thereby setting the gate electrode of the third transistor T3 in a floating state.

Transitioning from the third period p3 to the fourth period p4, the second clock signal is at a low level first, then transitions into a high level. Due to the coupling of the third capacitor C3, the potential at the gate electrode of the third transistor T3 is at a low level first, then transitions into a high level. The third transistor T3 turns on first, then turns off. The potential at the second node N2 is at a low level first, then the second node N2 floats, and the potential at the second node N2 remains at a low level. The low level at the second node N2 turns on the fourth transistor T4 and the sixth transistor T6. The second power supply signal VGH passes through the fourth transistor T4, the output terminal OUT outputs the second power supply signal VGH.

The sixth transistor T6 and the ninth transistor T9 are turned on, the second power supply signal VGH passes through the sixth transistor T6 and the ninth transistor T9, setting the potential at the first node N1 to a high level.

The eighth transistor T8 is turned on. The high level at the first node sets the potential at the fourth node N4 to a high level, turning off the fifth transistor T5. The output terminal OUT maintains a high level.

The inventors of the present disclosure discover that the tenth transistor T10 stabilizes the potential at the second node N2 when the third clock signal transitions from between the high level and the low level.

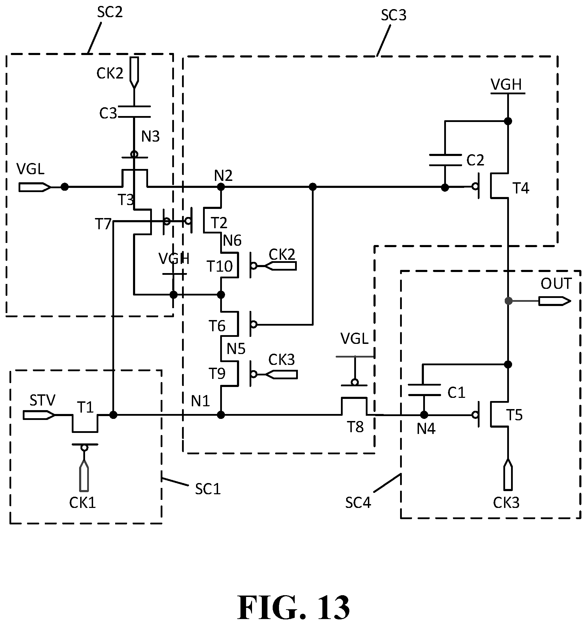

FIG. 13 is a schematic diagram of a respective shift register in some embodiments according to the present disclosure. Referring to FIG. 13, the respective shift register in some embodiments includes a first subcircuit SC1, a second subcircuit SC2, a third subcircuit SC3, and a fourth subcircuit SC4. The first subcircuit SC1 is connected to the second subcircuit SC2, and connected to the third subcircuit SC3. The second subcircuit SC2 is connected to the first subcircuit SC1, and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control the voltage of the first node N1 in response to signals provided to an input terminal IN and a first clock signal terminal CK1, respectively. In some embodiments, the first subcircuit SC1 includes a first transistor T1.

The first transistor T1 is coupled between the input terminal IN and a first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (e.g., when the respective shift register is a first stage shift register) or an output signal from an output terminal of a previous shift register (e.g., when the respective shift register is not the first stage shift register).

In some embodiments, a gate electrode of the first transistor T1 is coupled to a first clock signal terminal CK1, a first electrode of the first transistor T1 is coupled to an input terminal IN, a second electrode of the first transistor T1 is coupled to the first node N1.

In some embodiments, the second subcircuit SC2 is configured to control the voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3 (e.g., a third node N3), and coupled to a second electrode of the seventh transistor T7. A first electrode of the third transistor T3 is coupled to a first power supply signal VGL. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3, and coupled to the second capacitor electrode of the third capacitor C3.

A first capacitor electrode of the third capacitor C3 is coupled to the second clock signal terminal CK2. A second capacitor electrode of the third capacitor C3 is coupled to the gate electrode of the third transistor T3, and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, a tenth transistor T10, and a second capacitor C2.

A gate electrode of the second transistor T2 is coupled to the first node N1. A first electrode of the second transistor T2 is coupled to a second electrode of the tenth transistor T10. A second electrode of the second transistor T2 is coupled to the second node N2.

A gate electrode of the fourth transistor T4 is coupled to the second node N2. A first electrode of the fourth transistor T4 is configured to be provided with a second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with a second power supply signal VGH. A second electrode of the sixth transistor T6 is coupled to a first electrode of the ninth transistor T9 (a fifth node N5).

A gate electrode of the eighth transistor T8 is configured to be provided with a first power supply signal VGL. In one example, the first power supply signal VGL provides a continuous low level signal. A first electrode of the eighth transistor T8 is coupled to the first node N1. A second electrode of the eighth transistor T8 is coupled to the fourth node N4.

A gate electrode of the ninth transistor T9 is coupled to a third clock signal terminal CK3. A first electrode of the ninth transistor T9 is coupled to the second electrode of the sixth transistor T6 (the fifth node N5). A second electrode of the ninth transistor T9 is coupled to the first node N1.

A gate electrode of the tenth transistor T10 is coupled to the second clock signal terminal CK2. A first electrode of the tenth transistor T10 is configured to be provided with a second power supply signal VGH. A second electrode of the tenth transistor T10 is coupled to the first electrode of the second transistor T2 (a sixth node N6).

A first capacitor electrode of the second capacitor C2 is coupled to the second node N2. A second capacitor electrode of the second capacitor C2 is configured to be provided with a second power supply signal VGH.

In some embodiments, the fourth subcircuit SC4 includes a fifth transistor T5 and a first capacitor C1.

A gate electrode of the fifth transistor T5 is coupled to a fourth node N4. A first electrode of the fifth transistor T5 is coupled to the third clock signal terminal CK3. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

In some embodiments, the first clock signal terminal CK1, the second clock signal terminal CK2, and the third clock signal terminal CK3 are configured to receive different clock signals. Optionally, the first clock signal terminal CK1, the second clock signal terminal CK2, and the third clock signal terminal CK3 are configured to receive different clock signals that are out of phase with respect to each other.

In some embodiments, the first clock signal terminal CK1, the second clock signal terminal CK2, and the third clock signal terminal CK3 are configured to receive three different clock signals selected from N number of clock signals that are out of phase with respect to each other, wherein N > 3. Optionally, the N number of clock signals are phase-shifted relative to one another and are sequentially clocked in a systematic manner. In some embodiments, the clock signals received by the first clock signal terminal CK1, the second clock signal terminal CK2, and the third clock signal terminal CK3, respectively, are phase-shifted relative to one another and are sequentially clocked in a systematic manner.

In one example, the first clock signal terminal CK1, the second clock signal terminal CK2, and the third clock signal terminal CK3 are configured to receive three different clock signals selected from a first clock signal, a second clock signal, a third clock signal, and a fourth clock signal, wherein the first clock signal, the second clock signal, the third clock signal, and the fourth clock signal are out of phase with respect to each other. In another example, the first clock signal, the second clock signal, the third clock signal, and the fourth clock signal are phase-shifted relative to one another and are sequentially clocked in a systematic manner.

The inventors of the present disclosure discover that the shift register depicted in FIG. 13 can obviate the impact of voltage fluctuations at the gate of the fifth transistor T5, caused by the third clock signal jumping from the high level to the low level, which leads to circuit instability. The inventors of the present disclosure discover that the shift register depicted in FIG. 13 can, unexpectedly and surprisingly, enhances the circuit's stability and improves its adaptability under harsh environmental conditions.

The shift register depicted in FIG. 13 differs from the shift register depicted in FIG. 10 in that, in the shift register depicted in FIG. 10, the first capacitor electrode of the third capacitor C3 and the first electrode of the third transistor T3 are coupled to a third clock signal terminal CK3; whereas, in the shift register depicted in FIG. 13, the first capacitor electrode of the third capacitor C3 is coupled to the second clock signal terminal CK2, and the first electrode of the third transistor T3 is coupled to a first power supply signal VGL. In the shift register depicted in FIG. 10, the clock signal received by the first capacitor electrode of the third capacitor C3 and the first electrode of the third transistor T3 is the same as the clock signal received by the first electrode of the fifth transistor T5 and the gate electrode of the ninth transistor T9. In the shift register depicted in FIG. 13, the signal received by the first electrode of the third transistor T3 is the same as the signal received by the gate electrode of the eighth transistor T8.

FIG. 11 may be a timing diagram illustrating the operation of a shift register depicted in any one of FIG. 13. Referring to FIG. 11, the operation of the respective shift register in a frame of image includes a first period p1, a second period p2, a third period p3, and a fourth period p4. In some embodiments, the first period p1 may include a first subperiod p1-1 and a second subperiod p1-2. In some embodiments, the first clock signal terminal CK1, the second clock signal terminal CK2, and the third clock signal terminal CK3 are configured to receive three different clock signals selected from a first clock signal provided by a first clock signal line, a second clock signal provided by a second clock signal line, a third clock signal provided by a third clock signal line, and a fourth clock signal provided by a fourth clock signal line, wherein the first clock signal, the second clock signal, the third clock signal, and the fourth clock signal are out of phase with respect to each other. FIG. 11 illustrates a shift register in a stage in which the first clock signal terminal CK1 receives the first clock signal provided by the first clock signal line, the second clock signal terminal CK2 receives the second clock signal provided by the second clock signal line, and the third clock signal terminal CK3 receives the third clock signal provided by the third clock signal line. In one example, the first clock signal, the second clock signal, the third clock signal, and the fourth clock signal are phase-shifted relative to one another and are sequentially clocked in a systematic manner. In other stages, the shift register may receive clock signals of different combinations.

In the first subperiod p1-1, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a low level. The second clock signal received through the second clock signal terminal CK2 is at a high level. The third clock signal received through the third clock signal terminal CK3 is at a high level.

In the first subperiod p1-1, the first transistor T1 is turned on, the low level of the signal received through the input terminal IN sets the first node N1 and the fourth node N4 to low levels, and charges the first capacitor C1. The eighth transistor T8 is turned on.

In the first subperiod p1-1, the high level received through the second clock signal terminal CK2 turns off the tenth transistor T10.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the tenth transistor T10 is turned off. The second node N2 maintains a low level. The low level at the second node N2 turns on the fourth transistor T4, the second power supply signal VGH passes through the fourth transistor T4, and the output terminal OUT outputs a high level signal.

In the second subperiod p1-2, the signal received through the input terminal IN (e.g., a start signal (e.g., when the respective shift register is a first stage shift register) or an output signal from an output terminal of a previous shift register (e.g., when the respective shift register is not the first stage shift register) is at a low level. The signal received through the start signal terminal STV is at a low level. The first clock signal received through the first clock signal terminal CK1 is at a high level. The second clock signal received through the second clock signal terminal CK2 is at a low level. The third clock signal received through the third clock signal terminal CK3 is at a high level.

In the second subperiod p1-2, the first transistor T1 is turned off, the tenth transistor T10 is turned on. The first node N1 and the fourth node N4 maintain low levels. The second node N2 maintains a high level.

The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

The third transistor T3 is turned off, the second transistor T2 and the tenth transistor T10 are turned on. The second node N2 is charged with the second power supply signal VGH, which is at a high level. The high level at the second node N2 charges the second capacitor C2, and turns off the fourth transistor T4.

In the second subperiod p1-2, the fourth node N4 is at a low level, and the fifth transistor T5 is turned on. The third clock signal is at a high level. The third clock signal passes through the fifth transistor T5, and the output terminal OUT outputs a high level signal.

In the second period p2, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is at a low level.

In the second period p2, the first transistor T1 is turned off, the first node N1 maintains a low level due to absence of a discharging path. The low level at the first node N1 turns on the second transistor T2 and the seventh transistor T7. The second power supply signal VGH, which is at a high level, passes through the seventh transistor T7 to the gate electrode of the third transistor T3. The high level of the second power supply signal VGH turns off the third transistor T3.

In the second period p2, the high level received through the second clock signal terminal CK2 turns off the tenth transistor T10.

In the second period p2, the third transistor T3 remains turned off, the tenth transistor T10 is turned off. The second node N2 maintains a high level. The high level at the second node N2 turns off the sixth transistor T6.

In the second period p2, the first node N1 maintains a low level, the eighth transistor T8 is turned on, and the fourth node N4 also maintains a low level. The low level at the fourth node N4 turns on the fifth transistor T5. The third clock signal is at a low level. The third clock signal through the fifth transistor T5, and the output terminal OUT outputs a low level signal.

In the third period p3, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a low level. The second clock signal received through the second clock signal terminal CK2 is at a low level. The third clock signal received through the third clock signal terminal CK3 is at a high level.

Before the first clock signal transitions from the high level to the low level (as denoted as p3-1 in FIG. 11), the potentials at the first node N1 and the fourth node N4 remain at low levels as in the second period p2. Before the first clock signal transitions from the high level to the low level, the fifth transistor T5 remains turned on, and the output terminal OUT outputs a high level of the third clock signal.

After the first clock signal transitions from the high level to the low level (as denoted as p3-2 in FIG. 11), the first transistor T1 is turned on, pulling the potentials at the first node N1 and the fourth node N4 to high levels. The high level at the fourth node N4 turns off the fifth transistor T5, thereby resetting the respective shift register. The high level at the first node N1 turns off the second transistor T2 and the seventh transistor T7, thereby setting the gate electrode of the third transistor T3 in a floating state. The third transistor T3 remains turned off.

In the third period p3, subsequent to the second clock signal transitioning into a low level, the third transistor T3 is turned on. The low level provided by the first power supply signal VGL lowers the potential at the second node N2 to a low level, turning on the fourth transistor T4 and the sixth transistor T6. The output terminal OUT outputs a high level.

In the fourth period p4, the signal received through the input terminal IN (e.g., a start signal (e.g., when the respective shift register is a first stage shift register) or an output signal from an output terminal of a previous shift register (e.g., when the respective shift register is not the first stage shift register) is at a high level. The signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is at a low level.

In the fourth period p4, the high level received through the second clock signal terminal CK2 turns off the tenth transistor T10.

In the fourth period p4, the first transistor T1 is turned off, the first node N1 maintains a high level due to absence of a discharging path. The high level at the first node N1 turns off the second transistor T2 and the seventh transistor T7, thereby setting the gate electrode of the third transistor T3 in a floating state. The potential at the second node N2 maintains at a low level, turning on the fourth transistor T4 and the sixth transistor T6. The output terminal OUT outputs a high level.

The sixth transistor T6 and the ninth transistor T9 are turned on, the second power supply signal VGH passes through the sixth transistor T6 and the ninth transistor T9, setting the potential at the first node N1 to a high level.

The eighth transistor T8 is turned on. The high level at the first node sets the potential at the fourth node N4 to a high level, turning off the fifth transistor T5. The output terminal OUT maintains a high level.

The inventors of the present disclosure discover that the tenth transistor T10 stabilizes the potential at the second node N2 when the third clock signal transitions from between the high level and the low level.

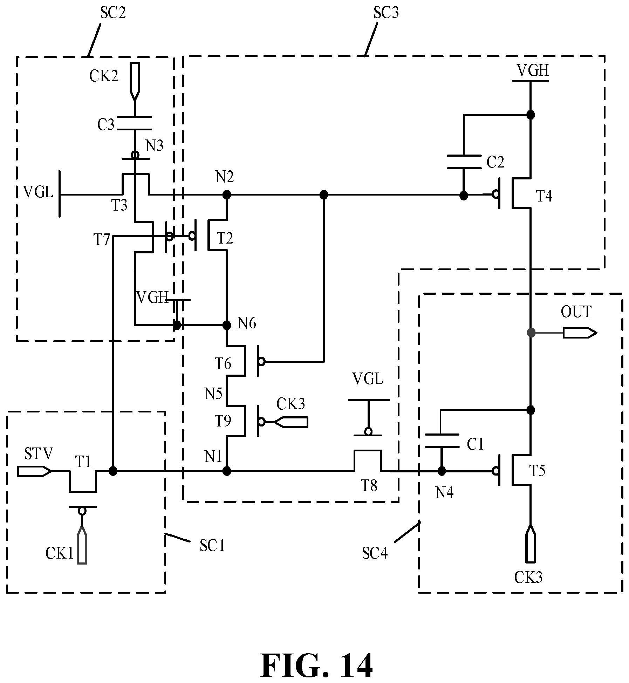

FIG. 14 is a schematic diagram of a respective shift register in a scan circuit in some embodiments according to the present disclosure. Referring to FIG. 14, in some embodiments, the shift register includes a first subcircuit SC1, a second subcircuit SC2, a third subcircuit SC3, and a fourth subcircuit SC4. The first subcircuit SC1 is connected to the second subcircuit SC2 and connected to the third subcircuit SC3. The second subcircuit SC2 is connected to the first subcircuit SC1 and connected to the third subcircuit SC3. The third subcircuit SC3 is connected to the first subcircuit SC1, connected to the second subcircuit SC2, and connected to the fourth subcircuit SC4. The fourth subcircuit SC4 is connected to the third subcircuit SC3.

In some embodiments, the first subcircuit SC1 is configured to control a voltage of a first node N1 in response to signals respectively provided to an input terminal IN and a first clock signal terminal CK1. In some embodiments, the first subcircuit SC1 includes a first transistor T1.

The first transistor T1 is coupled between the input terminal IN and the first node N1. A gate electrode of the first transistor T1 is coupled to the first clock signal terminal CK1. When a first clock signal is provided to the first clock signal terminal CK1, the first transistor T1 is turned on to electrically couple the input terminal IN to the first node N1. In some embodiments, the input terminal IN is configured to receive a start signal (for example, when the shift register is a first stage shift register), or an output signal from an output terminal of a shift register in a different stage (for example, when the shift register is not the first stage shift register). Therefore, in the embodiment shown in FIG. 14, the input terminal IN is the start signal terminal STV serving as a signal input terminal.

In some embodiments, a gate electrode of the first transistor T1 is coupled to the first clock signal terminal CK1, a first electrode of the first transistor T1 is coupled to the input terminal IN, and a second electrode of the first transistor T1 is coupled to the first node N1.

In some embodiments, the second subcircuit SC2 is configured to control a voltage of a second node N2. In some embodiments, the second subcircuit SC2 includes a third transistor T3, a seventh transistor T7, and a third capacitor C3.

A gate electrode of the third transistor T3 is coupled to a second capacitor electrode of the third capacitor C3, namely, a third node N3, and is coupled to a second electrode of the seventh transistor T7. A first electrode of the third transistor T3 is coupled to a first power supply signal VGL. A second electrode of the third transistor T3 is coupled to the second node N2.

A gate electrode of the seventh transistor T7 is coupled to the first node N1. A first electrode of the seventh transistor T7 is configured to be provided with a second power supply signal VGH. In one example, the second power supply signal VGH provides a continuous high level signal. A second electrode of the seventh transistor T7 is coupled to the gate electrode of the third transistor T3 and coupled to the second capacitor electrode of the third capacitor C3, namely, coupled to the third node N3.

A first capacitor electrode of the third capacitor C3 is coupled to a second clock signal terminal CK2. The second capacitor electrode of the third capacitor C3 is coupled to the gate electrode of the third transistor T3 and coupled to the second electrode of the seventh transistor T7.

In some embodiments, the third subcircuit SC3 includes a second transistor T2, a fourth transistor T4, a sixth transistor T6, an eighth transistor T8, a ninth transistor T9, and a second capacitor C2.

A gate electrode of the second transistor T2 is coupled to the first node N1. A first electrode of the second transistor T2 is configured to be provided with the second power supply signal VGH. A second electrode of the second transistor T2 is coupled to the second node N2.

A gate electrode of the fourth transistor T4 is coupled to the second node N2. A first electrode of the fourth transistor T4 is configured to be provided with the second power supply signal VGH. A second electrode of the fourth transistor T4 is coupled to an output terminal OUT.

A gate electrode of the sixth transistor T6 is coupled to the second node N2. A first electrode of the sixth transistor T6 is configured to be provided with the second power supply signal VGH. A second electrode of the sixth transistor T6 is coupled to a first electrode of the ninth transistor T9, namely, a fifth node N5.

A gate electrode of the eighth transistor T8 is configured to be provided with the first power supply signal VGL. In one example, the first power supply signal VGL provides a continuous low level signal. A first electrode of the eighth transistor T8 is coupled to the first node N1. A second electrode of the eighth transistor T8 is coupled to a fourth node N4.

A gate electrode of the ninth transistor T9 is coupled to a third clock signal terminal CK3. A first electrode of the ninth transistor T9 is coupled to the fifth node N5. A second electrode of the ninth transistor T9 is coupled to the first node N1.

A first capacitor electrode of the second capacitor C2 is coupled to the second node N2. A second capacitor electrode of the second capacitor C2 is configured to be provided with the second power supply signal VGH.

In some embodiments, the fourth subcircuit SC4 includes a fifth transistor T5 and a first capacitor C1.

A gate electrode of the fifth transistor T5 is coupled to the fourth node N4. A first electrode of the fifth transistor T5 is coupled to the third clock signal terminal CK3. A second electrode of the fifth transistor T5 is coupled to the output terminal OUT.

A first capacitor electrode of the first capacitor C1 is coupled to the fourth node N4. A second capacitor electrode of the first capacitor C1 is coupled to the output terminal OUT.

The shift register described in FIG. 14 differs from the shift register described in FIG. 13 in that the shift register described in FIG. 14 no longer includes the tenth transistor T10 connected between the second transistor T2 and the sixth transistor T6. Thus, the shift register in the embodiment shown in FIG. 14 includes nine transistors in total. In the shift register shown in FIG. 14, the first capacitor electrode of the third capacitor C3 is coupled to the second clock signal terminal CK2, the first electrode of the third transistor T3 is coupled to the first power supply signal VGL, and the second electrode of the third transistor T3 is coupled to the second node N2. In the circuit structure of the shift register shown in FIG. 14, a signal received by the first electrode of the third transistor T3 is the same as a signal received by the gate electrode of the eighth transistor T8, both being the first power supply signal VGL. A signal received by the gate electrode of the ninth transistor T9 is the same as a signal received by the first electrode of the fifth transistor T5, both being the third clock signal CK3.

FIG. 11 illustrates a timing diagram of operation of the shift register shown in FIG. 14. Referring to FIG. 11, in a frame of image, operation steps of the shift register include a first period p1, a second period p2, a third period p3, and a fourth period p4. In some embodiments, the first period p1 may include a first subperiod p1-1 and a second subperiod p1-2. In some embodiments, the first clock signal terminal CK1, the second clock signal terminal CK2, and the third clock signal terminal CK3 are configured to receive three different clock signals selected from a first clock signal provided by a first clock signal line GCK1, a second clock signal provided by a second clock signal line GCK2, a third clock signal provided by a third clock signal line GCK3, and a fourth clock signal provided by a fourth clock signal line GCK4. The first clock signal, the second clock signal, the third clock signal, and the fourth clock signal are out of phase with respect to each other. FIG. 11 illustrates one stage of a shift register in which the first clock signal terminal CK1 receives the first clock signal provided by the first clock signal line GCK1, the second clock signal terminal CK2 receives the second clock signal provided by the second clock signal line GCK2, and the third clock signal terminal CK3 receives the third clock signal provided by the third clock signal line GCK3. In one example, the first clock signal, the second clock signal, the third clock signal, and the fourth clock signal are sequentially phase shifted with respect to each other and are sequentially timed in a systematic manner. In other stages, the shift register may receive different combinations of clock signals from among the first clock signal, the second clock signal, the third clock signal, and the fourth clock signal.

In the embodiment shown in FIG. 11, in the first subperiod p1-1, a signal received through the input terminal IN, for example, a start signal (when the shift register is a first stage shift register), or an output signal from an output terminal of a previous stage shift register (when the shift register is not the first stage shift register), is at a low level. A signal received through the start signal terminal STV is at a low level. The first clock signal received through the first clock signal terminal CK1 is at a low level. The second clock signal received through the second clock signal terminal CK2 is at a high level. The third clock signal received through the third clock signal terminal CK3 is at a high level.

In the first subperiod p1-1, the first transistor T1 is turned on. The low level of the signal received through the input terminal IN sets the first node N1 and the fourth node N4 to low levels. The eighth transistor T8 is turned on, and the first capacitor C1 is charged.

The low level at the first node N1 turns on the second transistor T2 and the seventh transistor T7. The second power supply signal VGH, which is at a high level, is transmitted through the seventh transistor T7 to the gate electrode of the third transistor T3. The high level of the second power supply signal VGH turns off the third transistor T3.

The second transistor T2 is turned on. The second power supply signal VGH, which is at a high level, causes the second node N2 to be at a high level through the second transistor T2. The high level of the second node N2 turns off the fourth transistor T4.

The fourth node N4 is at a low level, so the fifth transistor T5 is turned on. The third clock signal, which is at a high level, is transmitted to the output terminal OUT through the fifth transistor T5, so that the output terminal OUT outputs a high level signal.

In the second subperiod p1-2, a signal received through the input terminal IN, for example, a start signal when the shift register is a first stage shift register, or an output signal from an output terminal of a previous shift register when the shift register is not the first stage shift register, is at a low level. A signal received through the start signal terminal STV is at a low level. The first clock signal received through the first clock signal terminal CK1 is at a high level. The second clock signal received through the second clock signal terminal CK2 is at a low level. The third clock signal received through the third clock signal terminal CK3 is at a high level.

In the second subperiod p1-2, the first transistor T1 is turned off, and the first node N1 and the fourth node N4 remain at low levels. The second node N2 remains at a high level.

The low level at the first node N1 turns on the second transistor T2 and the seventh transistor T7. The second power supply signal VGH, which is at a high level, is transmitted through the seventh transistor T7 to the gate electrode of the third transistor T3. The high level of the second power supply signal VGH turns off the third transistor T3.

The second node N2 is charged by the second power supply signal VGH, which is at a high level. The high level at the second node N2 charges the second capacitor C2 and turns off the fourth transistor T4.

In the second subperiod p1-2, the fourth node N4 is at a low level, and the fifth transistor T5 is turned on. The third clock signal is at a high level. The third clock signal passes through the fifth transistor T5, and the output terminal OUT outputs a high level signal.

In the second period p2, a signal received through the input terminal IN, for example, a start signal (when the shift register is a first stage shift register), or an output signal from an output terminal of a previous stage shift register (when the shift register is not the first stage shift register), is at a high level. A signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is at a low level.

In the second period p2, the first transistor T1 is turned off. Because there is no discharge path, the first node N1 remains at a low level. The low level at the first node N1 turns on the second transistor T2 and the seventh transistor T7. The second power supply signal VGH, which is at a high level, is transmitted through the seventh transistor T7 to the gate electrode of the third transistor T3. The high level of the second power supply signal VGH turns off the third transistor T3.

In the second period p2, the second transistor T2 is turned on. The second power supply signal VGH, which is at a high level, is transmitted to the second node N2 through the second transistor T2, and the second node N2 remains at a high level. The high level at the second node N2 turns off the sixth transistor T6, and the low level at the first node N1 is not transmitted to the second node N2.

In the second period p2, the first node N1 remains at a low level, the eighth transistor T8 is turned on, and the fourth node N4 also remains at a low level. The low level at the fourth node N4 turns on the fifth transistor T5. The third clock signal is at a low level in a former portion of the second period p2 and at a high level in a latter portion of the second period p2. The third clock signal reaches the output terminal OUT through the fifth transistor T5, so that the output terminal outputs a low level signal in the former portion of the second period p2 and outputs a high level signal in the latter portion of the second period p2. At this time, because the first node N1 remains at a low level, the second transistor T2 is turned on, the second power supply signal VGH at a high level keeps the second node N2 at a high level, and the sixth transistor T6 is in an off state. This differs from the embodiment shown in FIG. 13, in which the second node N2 is in a floating state at this stage due to the tenth transistor T10 being turned off. That is, the shift register in the embodiment shown in FIG. 14 can avoid the second node N2 being in a floating state when the output terminal OUT outputs a low level signal. If the second node N2 is in a floating state, the gate voltage of the fourth transistor T4 may be in a floating state and may be unstable, which may cause the second power supply signal VGH to reach the output terminal OUT through the fourth transistor T4 and affect the low level signal of the output terminal OUT.

In the third period p3, a signal received through the input terminal IN, for example, a start signal (when the shift register is a first stage shift register), or an output signal from an output terminal of a previous stage shift register (when the shift register is not the first stage shift register), is at a high level. A signal received through the start signal terminal STV is at a high level. In the third period p3, the first clock signal received through the first clock signal terminal CK1 is first at a high level, then transitions to a low level for a period of time, and then transitions to a high level. The second clock signal received through the second clock signal terminal CK2 is first at a high level and then transitions to a low level. The third clock signal received through the third clock signal terminal CK3 is at a high level. As shown in FIG. 11, in the third period p3, after the first clock signal transitions from a low level to a high level, the second clock signal switches from a high level to a low level.

Before the first clock signal transitions from the high level to the low level, as shown by a p3-1 turning point in FIG. 11, the first node N1 and the fourth node N4 remain at low levels, as in the second period p2. Before the first clock signal transitions from the high level to the low level, the fifth transistor T5 remains turned on, and the signal output from the output terminal OUT is the same as the third clock signal, both being high level signals.

After the first clock signal transitions from the high level to the low level, as shown by p3-2 in FIG. 11, the first transistor T1 is turned on, pulling the first node N1 and the fourth node N4 to high levels. The high level at the fourth node N4 turns off the fifth transistor T5, thereby resetting the shift register. The high level at the first node N1 turns off the second transistor T2 and the seventh transistor T7, thereby setting the gate electrode of the third transistor T3 in a floating state. The third transistor T3 remains turned off.

In the third period p3, after the second clock signal transitions to a low level, the third transistor T3 is turned on. The low level provided by the first power supply signal VGL lowers the potential at the second node N2 to a low level, thereby turning on the fourth transistor T4 and the sixth transistor T6. The output terminal OUT outputs a high level.

In the fourth period p4, a signal received through the input terminal IN, for example, a start signal (when the shift register is a first stage shift register), or an output signal from an output terminal of a previous stage shift register (when the shift register is not the first stage shift register, is at a high level). A signal received through the start signal terminal STV is at a high level. The first clock signal received through the first clock signal terminal CK1 is at a high level, the second clock signal received through the second clock signal terminal CK2 is at a high level, and the third clock signal received through the third clock signal terminal CK3 is at a low level.

In the fourth period p4, the first transistor T1 is turned off. Because there is no discharge path, the first node N1 remains at a high level. The high level at the first node N1 turns off the second transistor T2 and the seventh transistor T7, thereby setting the gate electrode of the third transistor T3 in a floating state. The potential at the second node N2 remains at a low level, thereby turning on the fourth transistor T4 and the sixth transistor T6. The output terminal OUT outputs a high level signal.

The sixth transistor T6 and the ninth transistor T9 are turned on. The second power supply signal VGH passes through the sixth transistor T6 and the ninth transistor T9, thereby setting the potential at the first node N1 to a high level.

The eighth transistor T8 is turned on. The high level at the first node N1 sets the potential at the fourth node N4 to a high level, thereby turning off the fifth transistor T5. The output terminal OUT remains at a high level.

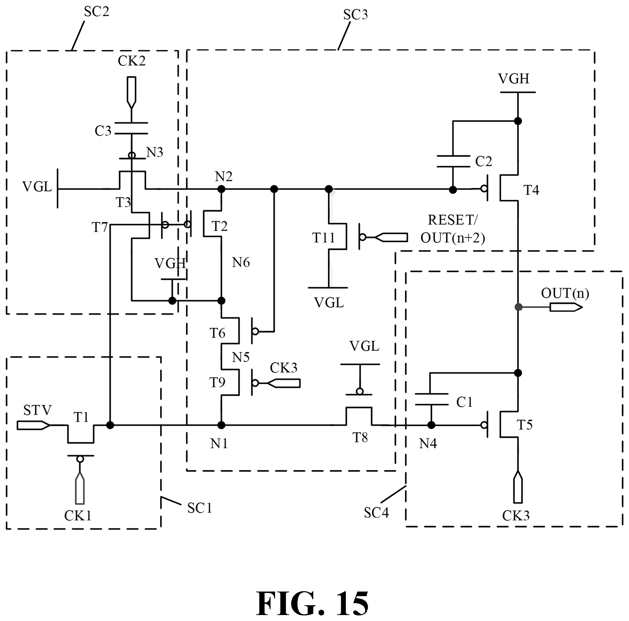

FIG. 15 is a schematic diagram illustrating a structure of a shift register in some embodiments according to the present disclosure. Different from the shift register shown in FIG. 14, the shift register shown in FIG. 15 further includes an eleventh transistor T11. A gate electrode of the eleventh transistor T11 is connected to a reset signal terminal RESET. A first electrode of the eleventh transistor T11 is connected to the first power supply signal VGL. A second electrode of the eleventh transistor T11 is connected to the second node N2, and is thereby connected to the gate electrode of the fourth transistor T4.

In this embodiment, the first electrode of the eleventh transistor T11 is connected to the first power supply signal VGL. Therefore, the eleventh transistor T11 may be regarded as a pull down transistor. A gate electrode of the eleventh transistor T11 may be output by an output terminal of a shift register two stages after the current shift register, that is, when the current shift register is an nth stage, the shift register two stages after is an (n+2)th stage shift register. That is, the gate electrode of the eleventh transistor T11 is connected to OUT(n+2). The shift register including the pull down transistor T11 may be turned on by a low level signal on the gate electrode of the eleventh transistor T11, thereby pulling down the level of the second node N2 to a low level and turning on the fourth transistor T4, so that the second power supply signal VGH passes through the fourth transistor T4 to the output terminal OUT, and the output terminal OUT outputs a high level signal. The purpose of providing the eleventh transistor T11 is to ensure that, when the first clock signal CK1 is at a low level to turn on high level output at the output terminal OUT, the floating state of the output terminal OUT is eliminated. That is, it is ensured that the output terminal OUT outputs a high level signal, and the floating state of the output terminal OUT when the first clock signal CK1 is turned on at a low level is eliminated.

FIG. 11 illustrates a timing diagram of operation of the shift register shown in FIG. 15. Referring to FIG. 11, in a frame of image, operation steps of the shift register include a first period p1, a second period p2, a third period p3, and a fourth period p4. In some embodiments, the first period p1 may include a first subperiod p1-1 and a second subperiod p1-2. In some embodiments, the first clock signal terminal CK1, the second clock signal terminal CK2, and the third clock signal terminal CK3 are configured to receive three different clock signals selected from a first clock signal provided by a first clock signal line GCK1, a second clock signal provided by a second clock signal line GCK2, a third clock signal provided by a third clock signal line GCK3, and a fourth clock signal provided by a fourth clock signal line GCK4. The first clock signal, the second clock signal, the third clock signal, and the fourth clock signal are out of phase with respect to each other. FIG. 11 illustrates one stage of a shift register in which the first clock signal terminal CK1 receives the first clock signal provided by the first clock signal line GCK1, the second clock signal terminal CK2 receives the second clock signal provided by the second clock signal line GCK2, and the third clock signal terminal CK3 receives the third clock signal provided by the third clock signal line GCK3. In one example, the first clock signal, the second clock signal, the third clock signal, and the fourth clock signal are sequentially phase shifted with respect to each other and are sequentially timed in a systematic manner. In other stages, the shift register may receive different combinations of clock signals from among the first clock signal, the second clock signal, the third clock signal, and the fourth clock signal.

In the embodiment shown in FIG. 11, in the first subperiod p1-1, a signal received through the input terminal IN, for example, a start signal when the shift register is a first stage shift register, or an output signal from an output terminal of a previous stage shift register when the shift register is not the first stage shift register, is at a low level. A signal received through the start signal terminal STV is at a low level. The first clock signal received through the first clock signal terminal CK1 is at a low level. The second clock signal received through the second clock signal terminal CK2 is at a high level. The third clock signal received through the third clock signal terminal CK3 is at a high level.

In the first subperiod p1-1, the first transistor T1 is turned on. The low level of the signal received through the input terminal IN sets the first node N1 and the fourth node N4 to low levels. The eighth transistor T8 is turned on, and the first capacitor C1 is charged.

The low level at the first node N1 turns on the second transistor T2 and the seventh transistor T7. The second power supply signal VGH, which is at a high level, is transmitted through the seventh transistor T7 to the gate electrode of the third transistor T3. The high level of the second power supply signal VGH turns off the third transistor T3.

The second transistor T2 is turned on. The second power supply signal VGH, which is at a high level, causes the second node N2 to be at a high level through the second transistor T2. The high level of the second node N2 turns off the fourth transistor T4.

The fourth node N4 is at a low level, so the fifth transistor T5 is turned on. The third clock signal, which is at a high level, is transmitted to the output terminal OUT through the fifth transistor T5, so that the output terminal OUT outputs a high level signal.

In the shift register shown in FIG. 14, in the first subperiod p1-1, the second node N2 is set to a high level through the first clock signal terminal CK1 and the start signal terminal STV at low levels, thereby turning off the fourth transistor T4. The first node N1 and the fourth node N4 are at low levels, thereby turning on the fifth transistor T5, so that a high level signal on the third clock signal terminal CK3 is output from the output terminal OUT.

In the second subperiod p1-2, a signal received through the input terminal IN, for example, a start signal when the shift register is a first stage shift register, or an output signal from an output terminal of a previous shift register when the shift register is not the first stage shift register, is at a low level. A signal received through the start signal terminal STV is at a low level. The first clock signal received through the first clock signal terminal CK1 is at a high level. The second clock signal received through the second clock signal terminal CK2 is at a low level. The third clock signal received through the third clock signal terminal CK3 is at a high level.

In the second subperiod p1-2, the first transistor T1 is turned off, and the first node N1 and the fourth node N4 remain at low levels. The second node N2 remains at a high level.

The low level at the first node N1 turns on the second transistor T2 and the seventh transistor T7. The second power supply signal VGH, which is at a high level, is transmitted through the seventh transistor T7 to the gate electrode of the third transistor T3. The high level of the second power supply signal VGH turns off the third transistor T3.

The second node N2 is charged by the second power supply signal VGH, which is at a high level. The high level at the second node N2 charges the second capacitor C2 and turns off the fourth transistor T4.

In the second subperiod p1-2, the fourth node N4 is at a low level, and the fifth transistor T5 is turned on. The third clock signal is at a high level. The third clock signal passes through the fifth transistor T5, and the output terminal OUT outputs a high level signal.

In the second period p2, a signal received through the input terminal IN, for example, a start signal when the shift register is a first stage shift register, or an output signal from an output terminal of a previous stage shift register when the shift register is not the first stage shift register, is at a high level. A signal received through the start signal terminal STV is at a high level. The first clock signal received through the first clock signal terminal CK1 is at a high level. The second clock signal received through the second clock signal terminal CK2 is at a high level. The third clock signal received through the third clock signal terminal CK3 is at a low level.

In the second period p2, the first transistor T1 is turned off. Because there is no discharge path, the first node N1 remains at a low level. The low level at the first node N1 turns on the second transistor T2 and the seventh transistor T7. The second power supply signal VGH, which is at a high level, is transmitted through the seventh transistor T7 to the gate electrode of the third transistor T3. The high level of the second power supply signal VGH turns off the third transistor T3.

In the second period p2, the second transistor T2 is turned on. The second power supply signal VGH, which is at a high level, is transmitted to the second node N2 through the second transistor T2, and the second node N2 remains at a high level. The high level at the second node N2 turns off the sixth transistor T6, and the low level at the first node N1 is not transmitted to the second node N2.

In the second period p2, the first node N1 remains at a low level, the eighth transistor T8 is turned on, and the fourth node N4 also remains at a low level. The low level at the fourth node N4 turns on the fifth transistor T5. The third clock signal is at a low level in a former portion of the second period p2 and at a high level in a latter portion of the second period p2. The third clock signal reaches the output terminal OUT through the fifth transistor T5, so that the output terminal outputs a low level signal in the former portion of the second period p2 and outputs a high level signal in the latter portion of the second period p2. At this time, because the first node N1 remains at a low level, the second transistor T2 is turned on, the second power supply signal VGH at a high level keeps the second node N2 at a high level, and the sixth transistor T6 is in an off state. This differs from the embodiment shown in FIG. 13, in which the second node N2 is in a floating state at this stage due to the tenth transistor T10 being turned off. That is, the shift register in the embodiment shown in FIG. 15 can avoid the second node N2 being in a floating state when the output terminal OUT outputs a low level signal. If the second node N2 is in a floating state, the gate voltage of the fourth transistor T4 may be in a floating state and may be unstable, which may cause the second power supply signal VGH to reach the output terminal OUT through the fourth transistor T4 and affect the low level signal of the output terminal OUT.

In the third period p3, a signal received through the input terminal IN, for example, a start signal (when the shift register is a first stage shift register), or an output signal from an output terminal of a previous stage shift register (when the shift register is not the first stage shift register), is at a high level. The first clock signal received through the first clock signal terminal CK1 is first at a high level, then transitions to a low level for a period of time, and then transitions to a high level. The second clock signal received through the second clock signal terminal CK2 is first at a high level and then transitions to a low level. The third clock signal received through the third clock signal terminal CK3 is at a high level. As shown in FIG. 11, in the third period p3, after the first clock signal transitions from a low level to a high level, the second clock signal switches from a high level to a low level.

Before the first clock signal transitions from the high level to the low level, as shown by p3-1 in FIG. 11, the first node N1 and the fourth node N4 remain at low levels, as in the second period p2. Before the first clock signal transitions from the high level to the low level, the fifth transistor T5 remains turned on, and the signal output from the output terminal OUT is the same as the third clock signal, both being high level signals.

After the first clock signal transitions from the high level to the low level, as shown by p3-2 in FIG. 11, the first transistor T1 is turned on, pulling the first node N1 and the fourth node N4 to high levels. The high level at the fourth node N4 turns off the fifth transistor T5. The high level at the first node N1 turns off the second transistor T2 and the seventh transistor T7, and the second node N2 remains at a high level. At this time, if the embodiment shown in FIG. 14 is adopted, both the fourth transistor T4 and the fifth transistor T5 are in an off state, and the output terminal OUT will be in a floating state. Therefore, to ensure the voltage at the output terminal OUT at this time, the eleventh transistor T11 is introduced at the gate terminal of the fourth transistor T4 in the embodiment of FIG. 15. The reset signal terminal RESET controlling the gate electrode of the eleventh transistor T11 is at a low level, so that the second node N2 is pulled down to turn on the fourth transistor T4, and the output terminal OUT is kept at a high level rather than being in a floating state. That is, for the shift register shown in FIG. 15, a signal timing of the reset signal terminal RESET is kept at a low level synchronously with the first clock signal in the third period p3, and is at a high level at other times.

In the third period p3, after the second clock signal transitions to a low level, the third transistor T3 is turned on. The low level provided by the first power supply signal VGL lowers the potential at the second node N2 to a low level, thereby turning on the fourth transistor T4 and the sixth transistor T6. The output terminal OUT outputs a high level.

In the fourth period p4, a signal received through the input terminal IN, for example, a start signal when the shift register is a first stage shift register, or an output signal from an output terminal of a previous stage shift register when the shift register is not the first stage shift register, is at a high level. A signal received through the start signal terminal STV is at a high level. In the fourth period p4, the first clock signal received through the first clock signal terminal CK1 is at a high level, the second clock signal received through the second clock signal terminal CK2 is at a high level, and the third clock signal received through the third clock signal terminal CK3 is at a low level.

In the fourth period p4, the first transistor T1 is turned off. Because there is no discharge path, the first node N1 remains at a high level. The high level at the first node N1 turns off the second transistor T2 and the seventh transistor T7, thereby setting the gate electrode of the third transistor T3 in a floating state. The potential at the second node N2 remains at a low level, thereby turning on the fourth transistor T4 and the sixth transistor T6. The output terminal OUT outputs a high level.

The sixth transistor T6 and the ninth transistor T9 are turned on. The second power supply signal VGH passes through the sixth transistor T6 and the ninth transistor T9, thereby setting the potential at the first node N1 to a high level.

The eighth transistor T8 is turned on. The high level at the first node N1 sets the potential at the fourth node N4 to a high level, thereby turning off the fifth transistor T5. The output terminal OUT remains at a high level.

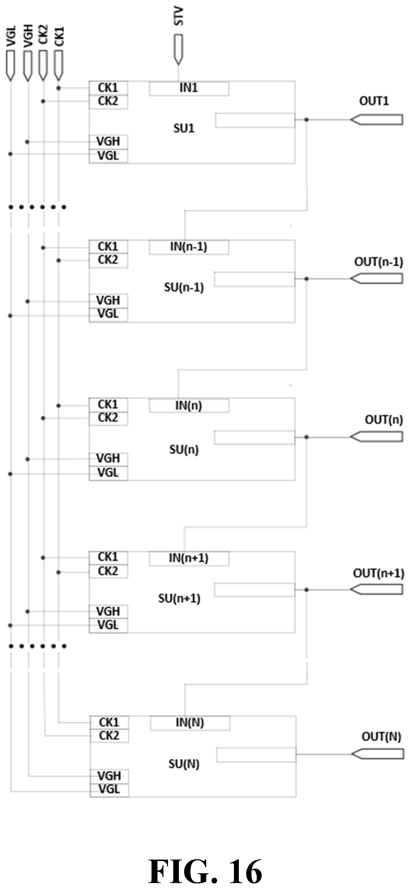

FIG. 16 is a schematic diagram illustrating a structure of a scan circuit including a plurality of stages of cascaded shift registers in some embodiments according to the present disclosure. The shift registers depicted in FIG. 16 may correspond to the shift registers depicted in FIG. 5 to FIG. 8. Referring to FIG. 16, the scan circuit in some embodiments includes N stages, including a first stage shift register SU1, ..., an (n-1)-th stage shift register SU(n-1), an n-th stage shift register SU(n), an (n+1)-th stage shift register SU(n+1), ..., an N-th stage shift register SU(N). A first input terminal IN1 of the first stage shift register SU1 receives a start signal from the start signal terminal STV. A (n-1)-th input terminal of the (n-1)-th stage shift register SU(n-1) receives an output signal from a previous stage (e.g., an (n-2)-th shift register in an (n-2)-th stage). A n-th input terminal of the n-th stage shift register SU(n) receives an output signal from the (n-1)-th stage shift register. A (n+1)-th input terminal of the (n+1)-th stage shift register receives an output signal from the n-th stage shift register. A N-th input terminal of the N-th stage shift register receives an output signal from an (N-1)-th stage shift register.

The first stage shift register SU1 outputs a first output signal from the first output terminal OUT1. The (n-1)-th stage shift register outputs an (n-1)-th output signal from the (n-1)-th output terminal OUT(n-1). The n-th stage shift register outputs an n-th output signal from the n-th output terminal OUT(n). The (n+1)-th stage shift register outputs an (n+1)-th output signal from the (n+1)-th output terminal OUT(n+1). The N-th stage shift register outputs an N-th output signal from the N-th output terminal OUT(N).

Each shift register receives a first clock signal from a first clock signal terminal CK1 and a second clock signal from a second clock signal terminal CK2. Each shift register receives a first power supply signal VGL and a second power supply signal VGH.

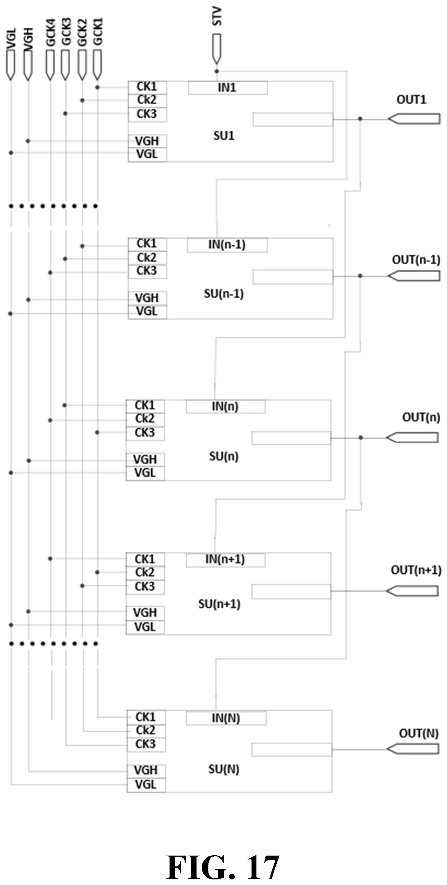

FIG. 17 is a schematic diagram of a scan circuit, including a plurality of cascaded shift registers in some embodiments according to the present disclosure. The scan circuit depicted in FIG. 17 may correspond to the shift register depicted in FIG. 10, FIG. 12, FIG. 13, or FIG. 14. Referring to FIG. 17, the scan circuit in some embodiments includes N stages, including a first stage shift register SU1, ..., an (n-1)-th stage shift register SU(n-1), an n-th stage shift register SU(n), an (n+1)-th stage shift register SU(n+1), ..., an N-th stage shift register SU(N). A first input terminal IN1 of the first stage shift register SU1 receives a start signal from the start signal terminal STV. A (n-1)-th input terminal of the (n-1)-th stage shift register receives an output signal from a previous stage (e.g., an (n-3)-th shift register in an (n-3)-th stage). A n-th input terminal of the n-th stage shift register receives an output signal from the (n-2)-th stage shift register. A (n+1)-th input terminal of the (n+1)-th stage shift register receives an output signal from the (n-1)-th stage shift register. A N-th input terminal of the N-th stage shift register receives an output signal from an (N-2)-th stage shift register.

The first stage shift register SU1 outputs a first output signal from the first output terminal OUT1. The (n-1)-th stage shift register SU(n-1) outputs an (n-1)-th output signal from the (n-1)-th output terminal OUT(n-1). The n-th stage shift register SU(n) outputs an n-th output signal from the n-th output terminal OUT(n). The (n+1)-th stage shift register SU(n+1) outputs an (n+1)-th output signal from the (n+1)-th output terminal OUT(n+1). The N-th stage shift register SU(N) outputs an N-th output signal from the N-th output terminal OUT(N).

Each shift register receives a first power supply signal VGL and a second power supply signal VGH.

Each shift register receives three different clock signals from a first clock signal terminal CK1, a second clock signal terminal CK2, and a third clock signal terminal CK3. The three different clock signals are selected from a first clock signal provided by a first clock signal line GCK1, a second clock signal provided by a second clock signal line GCK2, a third clock signal provided by a third clock signal line GCK3, and a fourth clock signal provided by a fourth clock signal line GCK4, wherein the first clock signal, the second clock signal, the third clock signal, and the fourth clock signal are out of phase with respect to each other.

In one example, the first shift register SU1 receives a first clock signal provided by a first clock signal line GCK1, a second clock signal provided by a second clock signal line GCK2, a third clock signal provided by a third clock signal line GCK3, and these signals are respectively input to the first clock signal terminal CK1, the second clock signal terminal CK2 and the third clock signal terminal CK3 of the first stage of shift register SU1. The (n-1)-th shift register SU(n-1) receives a second clock signal provided by a second clock signal line GCK2, a third clock signal provided by a third clock signal line GCK3, and a fourth clock signal provided by a fourth clock signal line GCK4, and these signals are respectively input to the first clock signal terminal CK1, the second clock signal terminal CK2 and the third clock signal terminal CK3 of the (n-1)-th stage of shift register SU(n-1). The n-th shift register SU(n) receives a third clock signal provided by a third clock signal line GCK3, a fourth clock signal provided by a fourth clock signal line GCK4, and a first clock signal provided by a first clock signal line GCK1, and these signals are respectively input to the first clock signal terminal CK1, the second clock signal terminal CK2 and the third clock signal terminal CK3 of the n-th stage of shift register SU(n). The (n+1)-th shift register SU(n+1) receives a fourth clock signal provided by a fourth clock signal line GCK4, a first clock signal provided by a first clock signal line GCK1, and a second clock signal provided by a second clock signal line GCK2, and these signals are respectively input to the first clock signal terminal CK1, the second clock signal terminal CK2 and the third clock signal terminal CK3 of the (n+1)-th stage of shift register SU(n+1). The N-th shift register SU(N) receives a first clock signal provided by a first clock signal line GCK1, a second clock signal provided by a second clock signal line GCK2, a third clock signal provided by a third clock signal line GCK3, and these signals are respectively input to the first clock signal terminal CK1, the second clock signal terminal CK2 and the third clock signal terminal CK3 of the N-th stage of shift register SU(N).

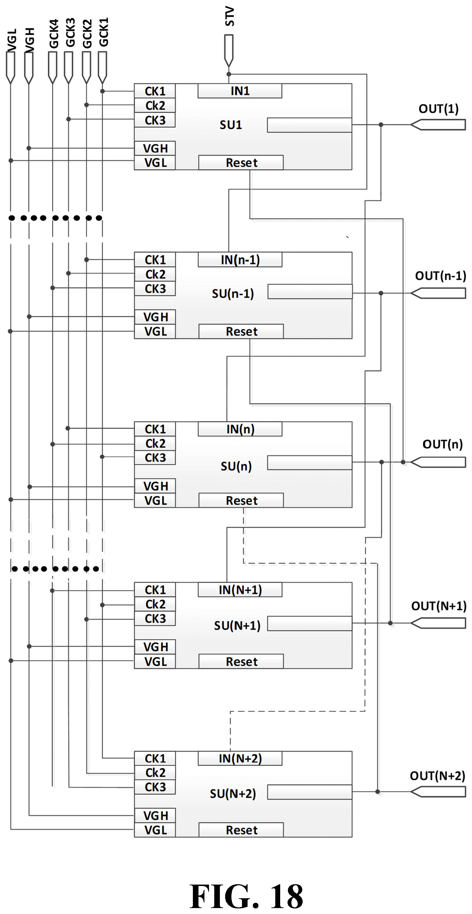

FIG. 18 is a schematic diagram illustrating a structure of a scan circuit including a plurality of cascaded stages of shift registers in some embodiments according to the present disclosure. The shift register shown in FIG. 18 may correspond to the shift register shown in FIG. 15. As compared with the shift register shown in FIG. 14, the shift register shown in FIG. 18 further includes an eleventh transistor T11, and therefore further includes a reset signal terminal RESET connected to a gate electrode of the eleventh transistor T11. Referring to FIG. 18, in some embodiments, the scan circuit includes N stages, including a first stage shift register SU1, ..., an (n-1)-th stage shift register SU(n-1), an n-th stage shift register SU(n), an (n+1)-th stage shift register SU(n+1), ..., and an N-th stage shift register SU(N). A first input terminal IN1 of the first stage shift register SU1 receives a start signal from a start signal terminal STV. An (n-1)-th input terminal of the (n-1)-th stage shift register SU(n-1) receives an output signal from a shift register two stages before, namely, an (n-3)-th stage shift register. An n-th input terminal of the n-th stage shift register receives an output signal from an (n-2)-th stage shift register. An (n+1)-th input terminal of the (n+1)-th stage shift register receives an output signal from the (n-1)-th stage shift register. An N-th input terminal of the N-th stage shift register receives an output signal from an (N-2)-th stage shift register.

A reset signal terminal RESET of the first stage shift register SU1 receives a first reset signal from a third output terminal OUT(3) of a third stage shift register SU3. A reset signal terminal RESET of the (n-1)-th stage shift register SU(n-1) receives an output signal from a shift register two stages after, namely, the (n+1)-th stage shift register. A reset signal terminal REST of the n-th stage shift register receives an output signal from the (n+2)-th stage shift register. A reset signal terminal RESET of the (n+1)-th stage shift register receives an output signal from the (n+3)-th stage shift register. An N-th input terminal of the N-th stage shift register receives an output signal from the (N-2)-th stage shift register.

The first stage shift register SU1 outputs a first output signal from a first output terminal OUT1. The (n-1)-th stage shift register SU(n-1) outputs an (n-1)-th output signal from an (n-1)-th output terminal OUT(n-1). The n-th stage shift register SU(n) outputs an n-th output signal from an n-th output terminal OUT(n). The (n+1)-th stage shift register SU(n+1) outputs an (n+1)-th output signal from an (n+1)-th output terminal OUT(n+1). The N-th stage shift register SU(N) outputs an N-th output signal from an N-th output terminal OUT(N).

Each shift register receives a first power supply signal VGL and a second power supply signal VGH.

Each shift register receives three different clock signals through its first clock signal terminal CK1, second clock signal terminal CK2, and third clock signal terminal CK3. The three different clock signals are selected from a first clock signal provided by a first clock signal line GCK1, a second clock signal provided by a second clock signal line GCK2, a third clock signal provided by a third clock signal line GCK3, and a fourth clock signal provided by a fourth clock signal line GCK4. The first clock signal, the second clock signal, the third clock signal, and the fourth clock signal are out of phase with respect to each other.

In one example, the first stage shift register SU1 receives the first clock signal provided by the first clock signal line GCK1, the second clock signal provided by the second clock signal line GCK2, and the third clock signal provided by the third clock signal line GCK3. These signals are respectively input to the first clock signal terminal CK1, the second clock signal terminal CK2, and the third clock signal terminal CK3 of the first stage shift register SU1. The (n-1)-th stage shift register SU(n-1) receives the second clock signal provided by the second clock signal line GCK2, the third clock signal provided by the third clock signal line GCK3, and the fourth clock signal provided by the fourth clock signal line GCK4. These clock signals are respectively input to the first clock signal terminal CK1, the second clock signal terminal CK2, and the third clock signal terminal CK3 of the (n-1)-th stage shift register SU(n-1). The n-th stage shift register SU(n) receives the third clock signal provided by the third clock signal line GCK3, the fourth clock signal provided by the fourth clock signal line GCK4, and the first clock signal provided by the first clock signal line GCK1. These clock signals are respectively input to the first clock signal terminal CK1, the second clock signal terminal CK2, and the third clock signal terminal CK3 of the n-th stage shift register SU(n). The (n+1)-th stage shift register SU(n+1) receives the fourth clock signal provided by the fourth clock signal line GCK4, the first clock signal provided by the first clock signal line GCK1, and the second clock signal provided by the second clock signal line GCK2. These clock signals are respectively input to the first clock signal terminal CK1, the second clock signal terminal CK2, and the third clock signal terminal CK3 of the (n+1)-th stage shift register SU(n+1). The N-th stage shift register SU(N) receives the first clock signal provided by the first clock signal line GCK1, the second clock signal provided by the second clock signal line GCK2, and the third clock signal provided by the third clock signal line GCK3. These clock signals are respectively input to the first clock signal terminal CK1, the second clock signal terminal CK2, and the third clock signal terminal CK3 of the N-th stage shift register SU(N).

In one aspect, the present disclosure provides a scan circuit. The scan circuit includes a plurality of cascaded shift registers. A respective shift register of the plurality of cascaded shift registers includes a first transistor T1 coupled between an input terminal IN and a first node N1; at least four transistors coupled between the first node N1 and a second node N2 in series, wherein the at least four transistors comprise a second transistor T2, a tenth transistor T10, a sixth transistor T6, and a ninth transistor T9; a fourth transistor T4 coupled between the second node N2 and an output terminal OUT; a fifth transistor coupled between the first node N1 and the output terminal OUT. Optionally, a gate electrode of the tenth transistor T10 is controlled by a signal that is at least partially in phase with respect to an effective voltage of a signal input to the input terminal IN. Optionally, a gate electrode of the first transistor T1 is controlled by a signal that is at least partially in phase with respect to the effective voltage of the signal input to the input terminal IN. Optionally, a gate electrode of the ninth transistor T9 is controlled by a signal that is out of phase with respect to the effective voltage of the signal input to the input terminal IN.

In some embodiments, the gate electrode of the ninth transistor T9 is controlled by a same signal provided to a first electrode of the fifth transistor T5 (see, e.g., CK2 in FIG. 5 to FIG. 8; CK3 in FIG. 10, FIG. 12, and FIG. 13).

In some embodiments, the second transistor T2, the tenth transistor T10, the sixth transistor T6, and the ninth transistor T9 are sequentially coupled between the first node N1 and a second node N2 in series (see, e.g., FIG. 5, FIG. 7, FIG. 10, FIG. 12, and FIG. 13).

In alternative embodiments, the tenth transistor T10, the second transistor T2, the sixth transistor T6, and the ninth transistor T9 are sequentially coupled between the first node N1 and a second node N2 in series (see, e.g., FIG. 6 and FIG. 8).

In some embodiments, the gate electrode of the tenth transistor T10 is controlled by a start signal, the gate electrode of the first transistor T1 is controlled by a first clock signal, and the gate electrode of the ninth transistor T9 is controlled by a second clock signal (see, e.g., FIG. 5 and FIG. 6). The first clock signal and the second clock signal are at least partially out of phase with respect to each other.

In alternative embodiments, gate electrodes of the tenth transistor T10 and the first transistor T1 is controlled by a first clock signal, and the gate electrode of the ninth transistor T9 is controlled by a second clock signal (see, e.g., FIG. 7 and FIG. 8). The first clock signal and the second clock signal are at least partially out of phase with respect to each other.

In alternative embodiments, the gate electrode of the tenth transistor T10 is controlled by a second clock signal, the gate electrode of the first transistor T1 is controlled by a first clock signal, and the gate electrode of the ninth transistor T9 is controlled by a third clock signal (see, e.g., FIG. 10, FIG. 12, and FIG. 13). The first clock signal, the second clock signal, and the third clock signal are at least partially out of phase with respect to each other.

In some embodiments, the respective shift register further includes a seventh transistor T7. A gate electrode of the seventh transistor T7 and the gate electrode of the second transistor T2 are coupled to the first node N1. First electrodes of the seventh transistor T7 and the sixth transistor T6 are configured to be provided with a second power supply signal VGH.

In some embodiments, a first electrode of the tenth transistor T10 is configured to be provided with the second power supply signal VGH. A second electrode of the tenth transistor T10 is coupled to a first electrode of the second transistor T2. A second electrode of the second transistor T2 is coupled to the second node N2 (see, e.g., FIG. 5, FIG. 7, FIG. 10, FIG. 12, and FIG. 13).

In alternative embodiments, a first electrode of the second transistor T2 is configured to be provided with the second power supply signal VGH. A second electrode of the second transistor T2 is coupled to a first electrode of the tenth transistor T10. A second electrode of the tenth transistor T10 is coupled to the second node N2 (see, e.g., FIG. 6 and FIG. 8).

In some embodiments, the respective shift register further includes a third transistor T3 and a third capacitor C3. A gate electrode of the third transistor T3 is coupled to a second electrode of the seventh transistor T7 and a second capacitor electrode of the third capacitor C3. A second electrode of the third transistor T3 is coupled to the second node N2.

In some embodiments, a first electrode of the third transistor T3 and the first capacitor electrode of the third capacitor C3 are configured to be provided with a same signal as a signal provided to the gate electrode of the ninth transistor T9 (see, e.g., FIG. 5 to FIG. 8, and FIG. 10).

In alternative embodiments, a first electrode of the third transistor T3 and the first capacitor electrode of the third capacitor C3 are configured to be provided with a same signal as a signal provided to the gate electrode of the tenth transistor T10 (see, e.g., FIG. 12).

In alternative embodiments, a first electrode of the third transistor T3 is configured to be provided with a same signal as a signal provided to the gate electrode of the eighth transistor T8 (see, e.g., FIG. 13).

In another aspect, the present disclosure further provides a method of operating a scan circuit including a plurality of shift registers. A respective shift register of the plurality of shift registers includes a first transistor T1 coupled between an input terminal IN and a first node N1; at least four transistors coupled between the first node N1 and a second node N2 in series, wherein the at least four transistors comprise a second transistor T2, a tenth transistor T10, a sixth transistor T6, and a ninth transistor T9; a fourth transistor coupled between the second node N2 and an output terminal OUT; a fifth transistor T5 coupled between the first node N1 and the output terminal OUT. In some embodiments, the method includes providing an effective voltage of a signal to the input terminal IN. Optionally, the method further includes providing a signal that is at least partially in phase with respect to an effective voltage of a signal input to the input terminal IN to control a gate electrode of the tenth transistor T10. Optionally, the method further includes providing a signal that is at least partially in phase with respect to the effective voltage of the signal input to the input terminal IN to control a gate electrode of the first transistor T1. Optionally, the method further includes providing a signal that is out of phase with respect to the effective voltage of the signal input to the input terminal IN to control a gate electrode of the ninth transistor T9.

In some embodiments, the method includes providing a control signal to the gate electrode of the ninth transistor T9, the control signal is the same as a signal provided to a first electrode of the fifth transistor T5 (see, e.g., CK2 in FIG. 5 to FIG. 8; CK3 in FIG. 10, FIG. 12, and FIG. 13).

In some embodiments, the method further includes sequentially coupling the second transistor T2, the tenth transistor T10, the sixth transistor T6, and the ninth transistor T9 in series between the first node N1 and a second node N2 (see, e.g., FIG. 5, FIG. 7, FIG. 10, FIG. 12, and FIG. 13).

In some embodiments, the method further includes sequentially coupling the tenth transistor T10, the second transistor T2, the sixth transistor T6, and the ninth transistor T9 in series between the first node N1 and a second node N2 (see, e.g., FIG. 6 and FIG. 8).

In some embodiments, the method further includes providing a start signal to the gate electrode of the tenth transistor T10 as a control signal; providing a first clock signal to the gate electrode of the first transistor T1 as a control signal; and providing a second clock signal to the gate electrode of the ninth transistor T9 (see, e.g., FIG. 5 and FIG. 6). The first clock signal and the second clock signal are at least partially out of phase with respect to each other.

In alternative embodiments, the method further includes providing a first clock signal to gate electrodes of the tenth transistor T10 and the first transistor T1 as a control signal; and providing a second clock signal to the gate electrode of the ninth transistor T9 as a control signal (see, e.g., FIG. 7 and FIG. 8). The first clock signal and the second clock signal are at least partially out of phase with respect to each other.

In alternative embodiments, the method further includes providing a second clock signal to the gate electrode of the tenth transistor T10 as a control signal; providing a first clock signal to the gate electrode of the first transistor T1 as a control signal; and providing a third clock signal to the gate electrode of the ninth transistor T9 as a control signal (see, e.g., FIG. 10, FIG. 12, and FIG. 13). The first clock signal, the second clock signal, and the third clock signal are at least partially out of phase with respect to each other.

In some embodiments, the respective shift register further includes a seventh transistor T7. In some embodiments, the method further includes coupling a gate electrode of the seventh transistor T7 and the gate electrode of the second transistor T2 to the first node N1; and providing a second power supply signal VGH to first electrodes of the seventh transistor T7 and the sixth transistor T6.

In some embodiments, the method further includes providing the second power supply signal VGH to a first electrode of the tenth transistor T10; coupling a second electrode of the tenth transistor T10 to a first electrode of the second transistor T2; and coupling a second electrode of the second transistor T2 to the second node N2 (see, e.g., FIG. 5, FIG. 7, FIG. 10, FIG. 12, and FIG. 13).

In alternative embodiments, the method further includes providing the second power supply signal VGH to a first electrode of the second transistor T2; coupling a second electrode of the second transistor T2 to a first electrode of the tenth transistor T10; and coupling a second electrode of the tenth transistor T10 to the second node N2 (see, e.g., FIG. 6 and FIG. 8).

In some embodiments, the respective shift register further includes a third transistor T3 and a third capacitor C3. In some embodiments, the method further includes coupling a gate electrode of the third transistor T3 to a second electrode of the seventh transistor T7 and a second capacitor electrode of the third capacitor C3; and coupling a second electrode of the third transistor T3 to the second node N2.

In some embodiments, the method further includes providing a same signal to a first electrode of the third transistor T3, the first capacitor electrode of the third capacitor C3, and the gate electrode of the ninth transistor T9 (see, e.g., FIG. 5 to FIG. 8, and FIG. 10).

In some embodiments, the method further includes providing a same signal to a first electrode of the third transistor T3, the first capacitor electrode of the third capacitor C3, and the gate electrode of the tenth transistor T10 (see, e.g., FIG. 12).

In some embodiments, the method further includes providing a same signal to a first electrode of the third transistor T3 and the gate electrode of the eighth transistor T8 (see, e.g., FIG. 13).

The foregoing description of the embodiments of the invention has been presented for purposes of illustration and description. It is not intended to be exhaustive or to limit the invention to the precise form or to exemplary embodiments disclosed. Accordingly, the foregoing description should be regarded as illustrative rather than restrictive. Obviously, many modifications and variations will be apparent to practitioners skilled in this art. The embodiments are chosen and described in order to explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like does not necessarily limit the claim scope to a specific embodiment, and the reference to exemplary embodiments of the invention does not imply a limitation on the invention, and no such limitation is to be inferred. The invention is limited only by the spirit and scope of the appended claims. Moreover, these claims may refer to use "first", "second", etc. following with noun or element. Such terms should be understood as a nomenclature and should not be construed as giving the limitation on the number of the elements modified by such nomenclature unless specific number has been given. Any advantages and benefits described may not apply to all embodiments of the invention. It should be appreciated that variations may be made in the embodiments described by persons skilled in the art without departing from the scope of the present invention as defined by the following claims. Moreover, no element and component in the present disclosure is intended to be dedicated to the public regardless of whether the element or component is explicitly recited in the following claims.

## Claims

1. A shift register, comprising:
a first transistor coupled between an input terminal and a first node; and
at least three transistors coupled in series between the first node and a second node, wherein the at least three transistors include a second transistor, a sixth transistor, and a ninth transistor;
wherein a gate electrode of the first transistor is controlled by a signal that is at least partially in phase with an effective voltage of a signal input to the input terminal; and
a gate electrode of the ninth transistor is controlled by a signal that is out of phase with the effective voltage of the signal input to the input terminal.

2. The shift register according to claim 1, further comprising a fifth transistor and an eighth transistor coupled between the first node and an output terminal;
wherein the gate electrode of the ninth transistor is controlled by a same signal provided to a first electrode of the fifth transistor, and a second electrode of the fifth transistor is connected to the output terminal; and
a first electrode of the eighth transistor is coupled to the first node, a second electrode of the eighth transistor is coupled to a gate electrode of the fifth transistor, and a gate electrode of the eighth transistor is provided with a first power supply signal.

3. The shift register according to claim 2, further comprising a seventh transistor, a third transistor, and a third capacitor;
wherein a gate electrode of the seventh transistor and a gate electrode of the second transistor are coupled to the first node;
a first electrode of the seventh transistor and a first electrode of the sixth transistor are configured to be provided with a second power supply signal;
a gate electrode of the third transistor is coupled to a second electrode of the seventh transistor and a second capacitor electrode of the third capacitor;
a second electrode of the third transistor is coupled to the second node; and
a first capacitor electrode of the third capacitor and a first electrode of the third transistor are coupled together, or the first capacitor electrode of the third capacitor is provided with a second clock signal and the first electrode of the third transistor is provided with the first power supply signal.

4. The shift register according to claim 3, further comprising a fourth transistor;
wherein a gate electrode of the fourth transistor is coupled to the second node, a first electrode of the fourth transistor is configured to be provided with the second power supply signal, and a second electrode of the fourth transistor is coupled to the output terminal.

5. The shift register according to any one of claims 1 to 4, further comprising a tenth transistor;
wherein a gate electrode of the tenth transistor is controlled by a signal that is at least partially in phase with an effective voltage of a signal input to the input terminal.

6. The shift register according to claim 5, wherein the second transistor, the tenth transistor, the sixth transistor, and the ninth transistor are sequentially coupled in series between the second node and the first node;
a first electrode of the tenth transistor is configured to be provided with a second power supply signal;
a second electrode of the tenth transistor is coupled to a first electrode of the second transistor; and
a second electrode of the second transistor is coupled to the second node.

7. The shift register according to claim 5, wherein the tenth transistor, the second transistor, the sixth transistor, and the ninth transistor are sequentially coupled in series between the second node and the first node;
a first electrode of the second transistor is configured to be provided with a second power supply signal;
a second electrode of the second transistor is coupled to a first electrode of the tenth transistor; and
a second electrode of the tenth transistor is coupled to the second node.

8. The shift register according to claim 6 or 7, wherein the gate electrode of the tenth transistor is controlled by a start signal;
the gate electrode of the first transistor is controlled by a first clock signal;
the gate electrode of the ninth transistor is controlled by a second clock signal; and
the first clock signal and the second clock signal are at least partially out of phase with respect to each other.

9. The shift register according to claim 6 or 7, wherein gate electrodes of the tenth transistor and the first transistor are controlled by a first clock signal;
the gate electrode of the ninth transistor is controlled by a second clock signal; and
the first clock signal and the second clock signal are at least partially out of phase with respect to each other.

10. The shift register according to claim 6 or 7, wherein the gate electrode of the tenth transistor is controlled by a second clock signal;
the gate electrode of the first transistor is controlled by a first clock signal;
the gate electrode of the ninth transistor is controlled by a third clock signal; and
the first clock signal, the second clock signal, and the third clock signal are at least partially out of phase with respect to each other.

11. The shift register according to claim 6 or 7, wherein the first electrode of a third transistor and a first capacitor electrode of a third capacitor are configured to be provided with a same signal as a signal provided to the gate electrode of the ninth transistor or the tenth transistor.

12. The shift register according to claim 4, wherein
the first capacitor electrode of the third capacitor is provided with a second clock signal, and the first electrode of the third transistor is provided with the first power supply signal;
the second transistor, the sixth transistor, and the ninth transistor are sequentially coupled in series between the second node and the first node;
a first electrode of the second transistor is provided with a second power supply signal, and a second electrode of the second transistor is coupled to the second node;
a second electrode of the sixth transistor is provided with the second power supply signal, a first electrode of the sixth transistor is connected to a second electrode of the ninth transistor, and a gate electrode of the sixth transistor is coupled to the second node; and
a first electrode of the ninth transistor is coupled to the first node, and the gate electrode of the ninth transistor is provided with a third clock signal.

13. The shift register according to claim 12, wherein
the gate electrode of the first transistor is controlled by a first clock signal;
the gate electrode of the ninth transistor is controlled by a third clock signal; and
the first clock signal, the second clock signal, and the third clock signal are at least partially out of phase with respect to each other.

14. The shift register according to claim 13, further comprising an eleventh transistor;
wherein a first electrode of the eleventh transistor is coupled to the second node, and a second electrode of the eleventh transistor is provided with the first power supply signal;
a gate electrode of the eleventh transistor is provided with a reset signal; and
the reset signal and the first clock signal are at least partially in phase with respect to each other.

15. A scan circuit, comprising a plurality of cascaded shift registers according to any one of claims 1 to 14.

16. A display apparatus, comprising the scan circuit according to claim 15, and a display panel driven by a signal output by the scan circuit.

17. A method of driving the shift register according to claim 8 or 9, comprising a first period, a second period, a third period, and a fourth period;
wherein in the first period, a signal received through the input terminal is at a low level, the signal received through the input terminal or the first clock signal is at a low level, the second clock signal is at a high level, the first transistor, an eighth transistor, the tenth transistor, and a fifth transistor are turned on, the first node is at a low level so that the second transistor and a seventh transistor are turned on, the second node is at a high level, a fourth transistor is turned off, and an output terminal outputs a high level signal;
in the second period, the signal received through the input terminal is at a high level, the first clock signal is at a high level, the second clock signal is at a low level, the first transistor is turned off, the first node is maintained at a low level, the second transistor and the seventh transistor are turned on, the second node is at a high level, the tenth transistor is turned off, the eighth transistor and the fifth transistor are turned on, and the output terminal outputs a low level signal;
in the third period, the signal received through the input terminal is at a high level, the first clock signal switches from a high level to a low level and then switches to a high level after lasting for a period of time, and the second clock signal is at a high level; before the first clock signal switches from the high level to the low level, the first transistor is turned off, the first node is maintained at a low level, the fifth transistor is turned on, and the output terminal outputs a high level signal; after the first clock signal switches from the high level to the low level, the first transistor is turned on, the first node is at a high level, the fifth transistor, the second transistor, and the seventh transistor are turned off, the second node is maintained at a high level, the fourth transistor is turned off, and the output terminal maintains the high level; and
in the fourth period, the signal received through the input terminal is at a high level, the first clock signal is at a high level, then switches from the high level to a low level and then switches to the high level after lasting for a period of time, and the second clock signal is at a low level, then switches from the low level to a high level and then switches to the low level after lasting for a period of time, wherein in the fourth period, a first duration in which the first clock signal is at the low level overlaps with a second duration in which the second clock signal is at the high level, and the first duration is less than the second duration; the first clock signal is at the high level, the first transistor is turned off, the first node is maintained at a high level, and the second transistor and the seventh transistor are turned off; and the second clock signal switches from the low level to the high level, the second node is at a low level and then floats and is then maintained at the low level, the fourth transistor is turned on, and the output terminal outputs a high level signal.

18. A method of driving the shift register according to claim 10, comprising a first period, a second period, a third period, and a fourth period;
wherein in the first period including a first subperiod and a second subperiod, in the first subperiod, a signal received through the input terminal is at a low level, the first clock signal is at a low level, the second clock signal is at a high level, the third clock signal is at a high level, the first transistor is turned on, the first node is at a low level, the second transistor and a seventh transistor are turned on, a second clock signal terminal is at a high level, and the tenth transistor is turned off; and in the second subperiod, the signal received through the input terminal is at a low level, the first clock signal is at a high level, the second clock signal is at a low level, the third clock signal is at a high level, the first transistor is turned off, the tenth transistor, the second transistor, and the seventh transistor are turned on, the first node is maintained at a low level, the second node is at a high level, a fourth transistor is turned off, the first node is at a low level, a fifth transistor is turned on, and an output terminal outputs a high level;
in the second period, the signal received through the input terminal is at a high level, the first clock signal is at a high level, the second clock signal is at a high level, the third clock signal is first at a low level and then transitions to a high level, the first transistor is turned off, the first node is maintained at a low level, the second transistor and the seventh transistor are turned on, the tenth transistor is turned off, the second node is maintained at a high level, the fourth transistor is turned off, the fifth transistor is turned on, and the output terminal outputs a low level;
in the third period, the signal received through the input terminal is at a high level, the first clock signal is first at a high level and then transitions to a low level and then transitions to a high level after lasting for a period of time, the second clock signal is first at a high level and then transitions to a low level, and the third clock signal is at a high level;
before the first clock signal transitions from the high level to the low level, the first transistor is turned off, the first node is maintained at a low level, the fifth transistor is turned on, and the output terminal outputs a high level signal; after the first clock signal transitions from the high level to the low level, the first transistor is turned on, the first node is at a high level, the fifth transistor is turned off, the second transistor and the seventh transistor are turned off, the second node is maintained at a high level, the fourth transistor is turned off, and the output terminal maintains outputting the high level signal; and
in the fourth period, the signal received through the input terminal is at a high level, the first clock signal is at a high level, the second clock signal is at a high level, the third clock signal is first at a low level and then transitions to a high level, the first transistor is turned off, the first node is maintained at a high level, the second transistor and the seventh transistor are turned off, the second node is maintained at a low level, the fourth transistor is turned on, and the output terminal outputs a high level signal.

19. A method of driving the shift register according to claim 13, comprising a first period, a second period, a third period, and a fourth period;
wherein in the first period including a first subperiod and a second subperiod, in the first subperiod, a signal received through the input terminal is at a low level, the first clock signal is at a low level, the second clock signal is at a high level, the third clock signal is at a high level, the first transistor is turned on, the first node is at a low level, the fifth transistor is turned on, the output terminal outputs a high level signal, the second transistor and the seventh transistor are turned on, the second node is at a high level, and the fourth transistor is turned off; and in the second subperiod, the signal received through the input terminal is at a low level, the first clock signal is at a high level, the second clock signal is at a low level, the third clock signal is at a high level, the first transistor is turned off, the first node is maintained at a low level, the second transistor and the seventh transistor are turned on, the second node is at a high level, the fourth transistor is turned off, the fifth transistor is turned on, and the output terminal outputs a high level signal;
in the second period, the signal received through the input terminal is at a high level, the first clock signal is at a high level, the second clock signal is at a high level, the third clock signal is at a low level, the first transistor is turned off, the first node is maintained at a low level, the second transistor and the seventh transistor are turned on, the second node is maintained at a high level, the sixth transistor is turned off, the fourth transistor is turned off, the fifth transistor is turned on, and the output terminal outputs a low level signal;
in the third period, the signal received through the input terminal is at a high level, the first clock signal is first at a high level and then transitions to a low level and then transitions to a high level after lasting for a period of time, the second clock signal is first at a high level and then transitions to a low level, and the third clock signal is at a high level;
before the first clock signal transitions from the high level to the low level, the first node is maintained at a low level, the fifth transistor is turned on, and the output terminal outputs a high level signal; after the first clock signal transitions from the high level to the low level, the second clock signal is at a low level, the first transistor is turned on, the first node is at a high level, the fifth transistor is turned off, the second transistor and the seventh transistor are turned off, the third transistor is turned on, the second node is at a low level, the fourth transistor is turned on, and the output terminal outputs a high level signal; and
in the fourth period, the signal received through the input terminal is at a high level, the first clock signal is at a high level, the second clock signal is at a high level, the third clock signal is at a low level, the first transistor is turned off, the first node is maintained at a high level, the second transistor and the seventh transistor are turned off, the second node is maintained at a low level, the fourth transistor is turned on, and the output terminal outputs a high level signal.

20. The method of driving the shift register according to claim 19, wherein the shift register further comprises an eleventh transistor;
wherein a first electrode of the eleventh transistor is coupled to the second node, a second electrode of the eleventh transistor is provided with the first power supply signal, a gate electrode of the eleventh transistor is provided with a reset signal, and the reset signal and the first clock signal are at least partially in phase with respect to each other; and
in the third period, the reset signal is caused to be in phase with the first clock signal, when the first clock signal transitions from a high level to a low level, the reset signal is also caused to transition from a high level to a low level, the eleventh transistor is turned on, the second node is at a low level, the fourth transistor is turned on, and the output terminal outputs a high level signal.
